# EUROPEAN PATENT APPLICATION

(11) **EP 4 607 598 A1**
(43) Date of publication of application: **27.08.2025**
(21) Application number: 23888477.9
(22) Date of filing: 23.10.2023
(51) Int. Cl.: H01L 33/22, H01L 33/56

(54) **SEMICONDUCTOR LIGHT-EMITTING ELEMENT AND LIGHT-EMITTING MODULE**

(30) Priority: 10.11.2022 JP 2022180383
(71) Applicant: National Institute of Information and Communications Technology, Koganei-shi, Tokyo 184-8795 (JP)
(72) Inventor: INOUE, Shinichiro, Koganei-shi, Tokyo 184-8795 (JP)
(74) Representative: Prüfer & Partner mbB Patentanwälte · Rechtsanwälte
(86) International application number: PCT/JP2023/038163
(87) International publication number: WO 2024/101126

(57) **Abstract**

A semiconductor light-emitting element (100, 200, 300) includes a substrate (10) and a semiconductor layer 20. The substrate has a first main surface (10a) and a second main surface (10b) opposite to the first main surface. The semiconductor layer includes: an n-type semiconductor layer (21) disposed on the first main surface; an active layer (22) disposed on the n-type semiconductor layer to generate deep ultraviolet light; and a p-type semiconductor layer (23) disposed on the active layer. The semiconductor layer has a mesa structure (24). The second main surface has a first region (10ba) facing the mesa structure and a second region (10bb) located around the first region. The first region is configured as a flat surface. The second region is provided with an uneven structure (10c, 10d). In a plan view, a width of the first region is 0.1 times or more and 3.0 times or less as large as a width of the mesa structure.

## Description

### TECHNICAL FIELD

The present disclosure relates to a semiconductor light-emitting element.

### BACKGROUND ART

For example, Japanese Patent Laying-Open No. 2018-174238 (PTL 1) discloses a semiconductor light-emitting element. The semiconductor light-emitting element disclosed in PTL 1 includes a substrate and a semiconductor layer. The substrate has a first main surface and a second main surface opposite to the first main surface. The semiconductor layer includes: an n-type semiconductor layer disposed on the first main surface; an active layer disposed on the n-type semiconductor layer; and a p-type semiconductor layer disposed on the active layer. The semiconductor layer has a mesa structure. The active layer generates deep ultraviolet light. An uneven structure is formed on the entire second main surface.

### CITATION LIST

### PATENT LITERATURE

PTL 1: Japanese Patent Laying-Open No. 2018-174238

### SUMMARY OF INVENTION

### TECHNICAL PROBLEM

There was a new finding about the semiconductor light-emitting element disclosed in PTL 1 that light emitted from a portion of the second main surface that faces the mesa structure was weak in intensity. Based on this finding, the present disclosure provides a semiconductor light-emitting element that is further enhanced in efficiency of extracting deep ultraviolet light.

### SOLUTION TO PROBLEM

A semiconductor light-emitting element of the present disclosure includes a substrate and a semiconductor layer. The substrate has a first main surface and a second main surface opposite to the first main surface. The semiconductor layer has: an n-type semiconductor layer disposed on the first main surface; an active layer disposed on the n-type semiconductor layer to generate deep ultraviolet light; and a p-type semiconductor layer disposed on the active layer. The semiconductor layer has a mesa structure. The second main surface has a first region facing the mesa structure and a second region located around the first region. The first region is configured as a flat surface. The second region is provided with an uneven structure. In a plan view, a width of the first region is 0.1 times or more and 3.0 times or less as large as a width of the mesa structure.

### ADVANTAGEOUS EFFECTS OF INVENTION

According to the semiconductor light-emitting element of the present disclosure, the extraction efficiency for deep ultraviolet light can be further enhanced.

### BRIEF DESCRIPTION OF DRAWINGS

Fig. 1 is a plan view of a semiconductor light-emitting element 100.
Fig. 2 is a plan view of semiconductor light-emitting element 100 as viewed from a side opposite to that shown in Fig. 1.
Fig. 3 is a cross-sectional view taken along III-III in Fig. 1.
Fig. 4 is a cross-sectional view of a semiconductor light-emitting element 100 according to a modification.
Fig. 5 is a diagram of a process for manufacturing semiconductor light-emitting element 100.
Fig. 6 is a cross-sectional view illustrating a preparing step S1.
Fig. 7 is a cross-sectional view illustrating a semiconductor layer forming step S2.
Fig. 8 is a cross-sectional view illustrating a mesa structure forming step S3.
Fig. 9 is a cross-sectional view illustrating a first electrode forming step S4.
Fig. 10 is a cross-sectional view illustrating a second electrode forming step S5.
Fig. 11 is a cross-sectional view illustrating a substrate back surface processing step S6.
Fig. 12A is a first cross-sectional view illustrating a mask forming step S7.
Fig. 12B is a second cross-sectional view illustrating mask forming step S7.
Fig. 12C is a third cross-sectional view illustrating mask forming step S7.
Fig. 12D is a fourth cross-sectional view illustrating mask forming step S7.
Fig. 13 is a cross-sectional view showing a columnar structure forming step S8.
Fig. 14A is a graph showing a relation between a current and an optical output in each of semiconductor light-emitting elements 100A and 100B.
Fig. 14B is a graph showing a relation between a current and an optical output in each of semiconductor light-emitting elements 100 and 100A.
Fig. 14C is an exemplary cross-sectional SEM image of semiconductor light-emitting elements 100 and 100B.
Fig. 15A is a graph showing a relation between a current and external quantum efficiency in each of semiconductor light-emitting elements 100A and 100B.
Fig. 15B is a graph showing a relation between a current and external quantum efficiency in each of semiconductor light-emitting elements 100 and 100B.
Fig. 16 is a graph showing a relation between a width W2 and enhancement in semiconductor light-emitting element 100.
Fig. 17 is a graph showing a relation between a thickness T and enhancement in semiconductor light-emitting element 100B.
Fig. 18 is a plan view of a semiconductor light-emitting element 200.
Fig. 19 is a plan view of semiconductor light-emitting element 200 as viewed from a side opposite to that shown in Fig. 18.
Fig. 20 is a cross-sectional view taken along XX-XX in Fig. 18.
Fig. 21 is a cross-sectional view of a semiconductor light-emitting element 200 according to a first modification.
Fig. 22 is a plan view of a semiconductor light-emitting element 200 according to a second modification.
Fig. 23 is a plan view of semiconductor light-emitting element 200 according to the second modification as viewed from a side opposite to that shown in Fig. 22.
Fig. 24A is a graph showing a relation between a current and an optical output in each of semiconductor light-emitting elements 200A and 200B.
Fig. 24B is a graph showing a relation between a current and an optical output in each of semiconductor light-emitting elements 200A and 200C.
Fig. 24C is a graph showing a relation between a current and an optical output in each of semiconductor light-emitting elements 200 and 200A.
Fig. 25A is a graph showing a relation between a current and external quantum efficiency in each of semiconductor light-emitting elements 200A and 200B.
Fig. 25B is a graph showing a relation between a current and external quantum efficiency in each of semiconductor light-emitting elements 200A and 200C.
Fig. 25C is a graph showing a relation between a current and external quantum efficiency in each of semiconductor light-emitting elements 200 and 200B.
Fig. 26A is a result of a near field pattern (NFP) analysis in semiconductor light-emitting element 200B.
Fig. 26B is an NFP analysis in semiconductor light-emitting element 200 on condition that a diameter D2 is 50 µm.
Fig. 26C is a result of the NFP analysis in semiconductor light-emitting element 200 on condition that diameter D2 is 80 µm.
Fig. 26D is a result of the NFP analysis in semiconductor light-emitting element 200 on condition that diameter D2 is 100 µm.
Fig. 26E is a result of the NFP analysis in semiconductor light-emitting element 200 on condition that diameter D2 is 120 µm.
Fig. 26F is a result of the NFP analysis in semiconductor light-emitting element 200 on condition that diameter D2 is 150 µm.
Fig. 26G is a result of the NFP analysis in semiconductor light-emitting element 200 on condition that diameter D2 is 300 µm.
Fig. 26H is a result of an NFP analysis in a semiconductor light-emitting element 200C.
Fig. 27 is a graph showing a relation between diameter D2 and enhancement in semiconductor light-emitting element 200.
Fig. 28A is a graph showing a relation between the current and the optical output in each of semiconductor light-emitting elements 200A and 200B on condition that mesa structure 24 is more than one in number.
Fig. 28B is a graph showing a relation between the current and the optical output in each of semiconductor light-emitting elements 200A and 200C on condition that mesa structure 24 is more than one in number.
Fig. 28C is a graph showing a relation between the current and the optical output in each of semiconductor light-emitting elements 200 and 200A on condition that mesa structure 24 is more than one in number.
Fig. 29A is a graph showing a relation between the current and the external quantum efficiency in each of semiconductor light-emitting elements 200A and 200B on condition that mesa structure 24 is more than one in number.
Fig. 29B is a graph showing a relation between the current and the external quantum efficiency in each of semiconductor light-emitting elements 200A and 200C on condition that mesa structure 24 is more than one in number.
Fig. 29C is a graph showing a relation between the current and the external quantum efficiency in each of semiconductor light-emitting elements 200 and 200B on condition that mesa structure 24 is more than one in number.
Fig. 30 is a plan view of a semiconductor light-emitting element 300.
Fig. 31 is a plan view of semiconductor light-emitting element 300 as viewed from a side opposite to that shown in Fig. 30.
Fig. 32 is a cross-sectional view taken along XXXII-XXXII in Fig. 30.
Fig. 33 is a plan view of a semiconductor light-emitting element 300 according to a modification.
Fig. 34 is a plan view of semiconductor light-emitting element 300 according to the modification as viewed from a side opposite to that shown in Fig. 33.
Fig. 35A is a graph showing a relation between an emission angle and intensity of deep ultraviolet light extracted from a second main surface 10b in each of semiconductor light-emitting elements 300 and 300A on condition that a diameter D3 is 210 µm.
Fig. 35B is a graph showing a relation between the emission angle and the intensity of deep ultraviolet light extracted from second main surface 10b in each of semiconductor light-emitting elements 300 and 300A on condition that diameter D3 is 250 µm.
Fig. 35C is a graph showing a relation between the emission angle and the intensity of deep ultraviolet light extracted from second main surface 10b in each of semiconductor light-emitting elements 300 and 300A on condition that diameter D3 is 333 µm.
Fig. 35D is a graph showing a relation between the emission angle and the intensity of deep ultraviolet light extracted from second main surface 10b in each of semiconductor light-emitting elements 300 and 300A on condition that diameter D3 is 500 µm.
Fig. 35E is a graph showing a relation between the emission angle and the intensity of deep ultraviolet light extracted from second main surface 10b in each of semiconductor light-emitting elements 300 and 300A on condition that diameter D3 is 1000 µm.
Fig. 35F is a graph showing a relation between the emission angle and the intensity of deep ultraviolet light extracted from second main surface 10b in each of semiconductor light-emitting elements 300 and 300A on condition that diameter D3 is 2000 µm.
Fig. 36 is a graph showing a relation between diameter D3 and enhancement in semiconductor light-emitting element 300.
Fig. 37A is a graph showing a relation between the emission angle and the intensity of the deep ultraviolet light extracted from second main surface 10b in semiconductor light-emitting element 300 on condition that a constituent material of a substrate 10 is sapphire.
Fig. 37B is a graph showing a relation between the emission angle and the intensity of the deep ultraviolet light extracted from second main surface 10b in semiconductor light-emitting element 300 on condition that a constituent material of substrate 10 is aluminum nitride.
Fig. 38A is a graph showing a relation between a current and external quantum efficiency in each of semiconductor light-emitting elements 300 and 300A.
Fig. 38B is a graph showing a relation between a current and an optical output in each of semiconductor light-emitting elements 300 and 300A.
Fig. 39 is a cross-sectional view of a light-emitting module 400.
Fig. 40 is a cross-sectional view of a light-emitting module 400 according to a modification.

### DESCRIPTION OF EMBODIMENTS

Details of embodiments of the present disclosure will be hereinafter described with reference to the accompanying drawings. In the drawings referred to below, the same or corresponding portions are denoted by the same reference characters, and redundant description will not be repeated.

### (First Embodiment)

A semiconductor light-emitting element (referred to as a semiconductor light-emitting element 100) according to the first embodiment will be hereinafter described.

### <Configuration of Semiconductor Light-Emitting Element 100>

The following describes a configuration of semiconductor light-emitting element 100.

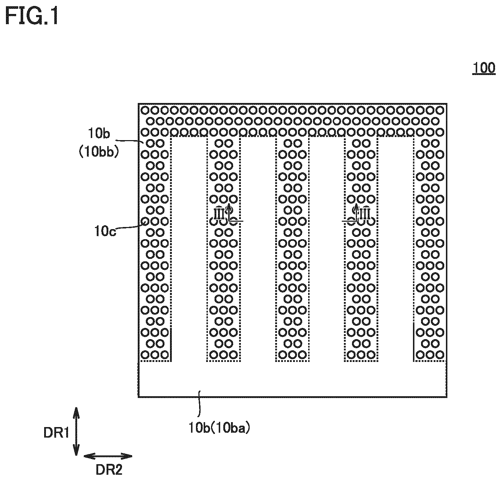

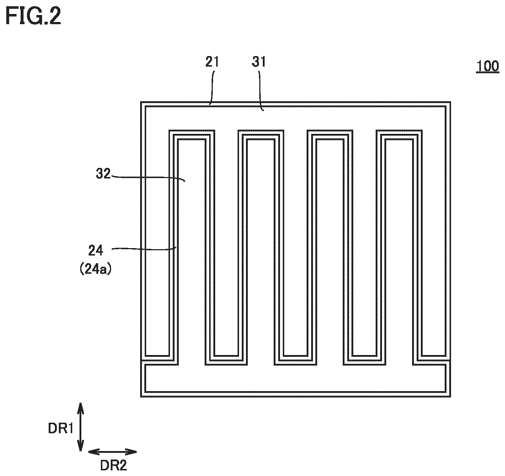

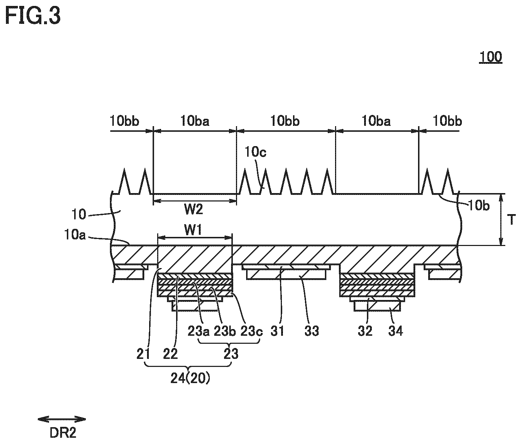

Fig. 1 is a plan view of semiconductor light-emitting element 100. Fig. 2 is a plan view of semiconductor light-emitting element 100 as viewed from the side opposite to that shown in Fig. 1. Fig. 2 does not show a pad electrode 33 and a pad electrode 34. Fig. 3 is a cross-sectional view taken along III-III in Fig. 1. As shown in Figs. 1 to 3, semiconductor light-emitting element 100 includes a substrate 10, a semiconductor layer 20, an n-electrode 31, a p-electrode 32, and pad electrodes 33 and 34.

Substrate 10 has a first main surface 10a and a second main surface 10b. First main surface 10a and second main surface 10b are end surfaces of substrate 10 in a thickness direction thereof. Second main surface 10b is a surface opposite to first main surface 10a. The thickness of substrate 10 is defined as a thickness T. Thickness T is, for example, 30 µm or more. Thickness T is preferably 50 µm or more, and more preferably 90 µm or more. Thickness T is a distance between first main surface 10a and a portion of second main surface 10b where an uneven structure 10c described later is not formed.

The constituent material of substrate 10 is, for example, a single crystal of aluminum nitride (AlN). The constituent material of substrate 10 is preferably a single crystal of aluminum nitride produced by a sublimation method (physical vapor transport: PVT). The constituent material of substrate 10 may be a single crystal of sapphire. The absorption coefficient of substrate 10 with respect to deep ultraviolet light may be 1 cm⁻¹ or more and 50 cm⁻¹ or less. The deep ultraviolet light has a wavelength of 100 nm or more and 350 nm or less, and more narrowly, has a wavelength of 200 nm or more and 300 nm or less.

Semiconductor layer 20 includes an n-type semiconductor layer 21, an active layer 22, and a p-type semiconductor layer 23. Further, n-type semiconductor layer 21 is disposed on first main surface 10a. Active layer 22 is disposed on n-type semiconductor layer 21. Further, p-type semiconductor layer 23 includes an electron blocking layer 23a disposed on active layer 22, a cladding layer 23b disposed on electron blocking layer 23a, and a contact layer 23c disposed on cladding layer 23b.

The constituent material of n-type semiconductor layer 21 is, for example, AlGaN or AlInGaN. The constituent material of n-type semiconductor layer 21 is doped with n-type impurities. Examples of the n-type impurities include silicon (Si), germanium (Ge), tin (Sn), oxygen (O), carbon (C), and the like.

Active layer 22 has, for example, a multiple quantum well (MQW) structure. More specifically, active layer 22 includes well layers and barrier layers that are alternately stacked. The constituent material of the well layer is, for example, AlInGaN. The constituent material of the barrier layer is, for example, AlGaN or AlInGaN. Deep ultraviolet light is generated from active layer 22.

The constituent material of electron blocking layer 23a is, for example, AlGaN or AlN. The constituent material of cladding layer 23b is, for example, AlGaN. The constituent material of contact layer 23c is, for example, GaN. The constituent material of p-type semiconductor layer 23 is doped with p-type impurities. Examples of the p-type impurities include magnesium (Mg), zinc (Zn), beryllium (Be), and the like.

Semiconductor layer 20 has a mesa structure 24. Around mesa structure 24, active layer 22 and p-type semiconductor layer 23 are removed so as to expose n-type semiconductor layer 21. Mesa structure 24 has a plurality of straight portions 24a extending in a first direction DR1 in a plan view. The plurality of straight portions 24a are arranged at intervals in a second direction DR2. Second direction DR2 is orthogonal to first direction DR1 in a plan view. Mesa structure 24 has, for example, a shape like teeth of a comb in a plan view. The width of straight portion 24a in second direction DR2 is defined as a width W1.

Second main surface 10b has a first region 10ba and a second region 10bb. First region 10ba faces mesa structure 24. More specifically, first region 10ba has a portion facing straight portion 24a. In a plan view, the center of first region 10ba in second direction DR2 preferably overlaps with a region of straight portion 24a. In a plan view, the distance between the center of first region 10ba in second direction DR2 and the center of straight portion 24a in second direction DR2 is preferably 0.2 times or less as large as width W1, and more preferably 0.05 times or less as large as width W1. In a plan view, the center of first region 10ba in second direction DR2 most preferably coincides with the center of straight portion 24a in second direction DR2. First region 10ba is configured as a flat surface.

The width of first region 10ba in second direction DR2 that faces straight portion 24a is defined as a width W2. Width W2 is preferably 0.1 times or more as large as width W1, and more preferably 0.4 times or more and 1.8 times or less as large as width W1. The lower limit value of width W2 is preferably 0.8 times or 1.0 times as large as width W1. The upper limit value of width W2 is preferably 1.5 times or 1.25 times as large as width W1.

Second region 10bb is provided with uneven structure 10c. Uneven structure 10c has a structure in which protrusions or holes are arranged, for example, the protrusions or the holes each having a conical shape, a polygonal pyramid shape, a truncated conical shape, a truncated polygonal pyramid shape, a circular cylindrical shape, a polygonal cylindrical shape, or the like. Preferably, the protrusions or holes included in uneven structure 10c are periodically arranged in a plan view. More specifically, the protrusions or holes included in uneven structure 10c are preferably arranged in a lattice pattern (a square lattice pattern, a staggered lattice pattern, a regular triangular lattice pattern, or the like) in a plan view. The protrusions or holes included in uneven structure 10c may be randomly arranged in a plan view. The aspect ratio of each protrusion or hole included in uneven structure 10c is, for example, 0.6 or more. The lower limit value of the aspect ratio of each protrusion or hole included in uneven structure 10c may be 0.8, 1.0, or 1.5, and the upper limit value of the aspect ratio of each protrusion or hole included in uneven structure 10c may be 3, 5, or 10. The aspect ratio of each protrusion or hole included in uneven structure 10c is a value obtained by dividing the height of the protrusion or hole of uneven structure 10c by the width of the bottom portion of the protrusion or hole in uneven structure 10c (for example, the diameter of the bottom portion of the protrusion in the case where each protrusion included in uneven structure 10c has a conical shape). Uneven structure 10c has a period of 1000 nm or less, for example. The period of uneven structure 10c is an interval between two adjacent protrusions or two adjacent holes included in uneven structure 10c.

Further, n-electrode 31 is disposed on n-type semiconductor layer 21 exposed from between mesa structures 24 in a plan view. Further, p-electrode 32 is disposed on p-type semiconductor layer 23 (more specifically, contact layer 23c). The constituent materials of n-electrode 31 and p-electrode 32 are, for example, metal materials. Further, n-electrode 31 is formed, for example, by stacking a titanium (Ti) layer, an aluminum layer, and a gold (Au) layer in this order from the n-type semiconductor layer 21 side. Further, p-electrode 32 is formed, for example, by stacking a nickel (Ni) layer and a gold layer in this order from the p-type semiconductor layer 23 side.

Pad electrode 33 is disposed on n-electrode 31. The constituent material of pad electrode 33 is, for example, a metal material. Pad electrode 33 is formed by stacking a titanium layer, a nickel layer, and a gold layer in this order from the n-electrode 31 side. Pad electrode 34 is disposed on p-electrode 32. The constituent material of pad electrode 34 is, for example, a metal material. Pad electrode 34 is formed by stacking a titanium layer, a nickel layer, and a gold layer in this order from the p-electrode 32 side.

### <Modification>

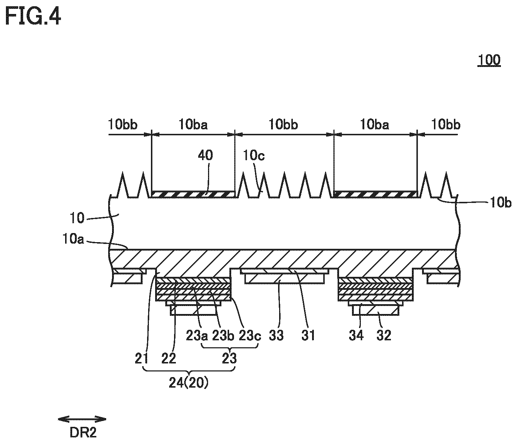

Fig. 4 is a cross-sectional view of a semiconductor light-emitting element 100 according to a modification. As shown in Fig. 4, semiconductor light-emitting element 100 may further include an anti-reflection film 40. Anti-reflection film 40 is disposed on first region 10ba. The constituent material of anti-reflection film 40 is, for example, silicon dioxide (SiO2) or aluminum oxide (Al₂O₃).

### <Method of Manufacturing Semiconductor Light-Emitting Element 100>

The following describes a method of manufacturing semiconductor light-emitting element 100.

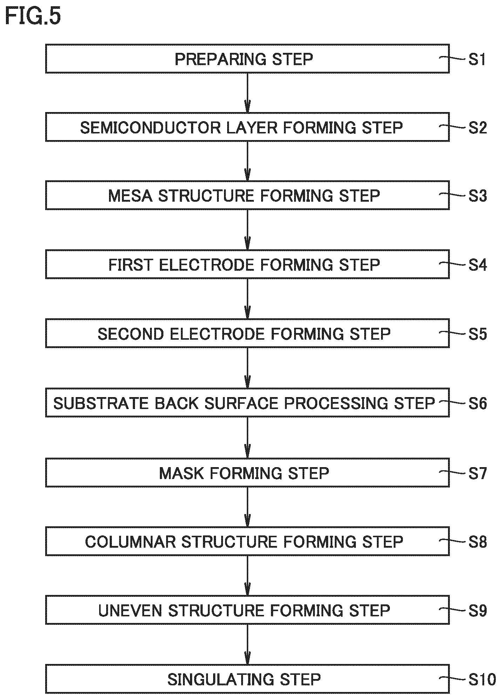

Fig. 5 is a diagram of a process for manufacturing semiconductor light-emitting element 100. As shown in Fig. 5, the method of manufacturing semiconductor light-emitting element 100 includes a preparing step S1, a semiconductor layer forming step S2, a mesa structure forming step S3, a first electrode forming step S4, a second electrode forming step S5, a substrate back surface processing step S6, a mask forming step S7, a columnar structure forming step S8, an uneven structure forming step S9, and a singulating step S10.

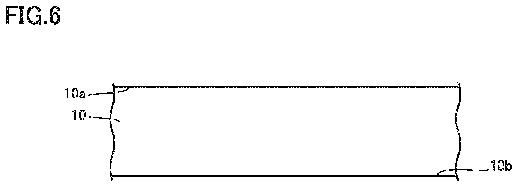

In the method of manufacturing semiconductor light-emitting element 100, preparing step S1 is first performed. Fig. 6 is a cross-sectional view illustrating preparing step S1. As shown in Fig. 6, in preparing step S1, substrate 10 is prepared. **In** substrate 10 prepared in preparing step S1, semiconductor layer 20 is not formed on first main surface 10a, and uneven structure 10c is not formed in second main surface 10b. The thickness of substrate 10 prepared in preparing step S1 is larger than thickness T.

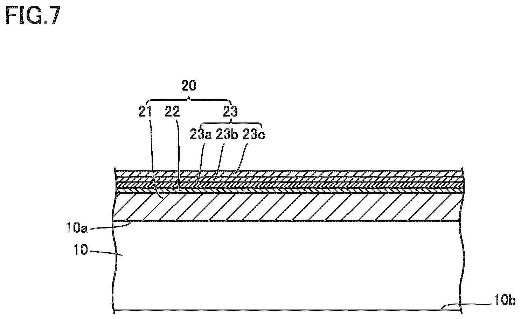

Semiconductor layer forming step S2 is performed after preparing step S1. Fig. 7 is a cross-sectional view illustrating semiconductor layer forming step S2. As shown in Fig. 7, in semiconductor layer forming step S2, semiconductor layer 20 is formed. Each of layers constituting semiconductor layer 20 is formed, for example, by a metal organic chemical vapor deposition (MOCVD) method. After semiconductor layer 20 is formed, annealing is performed to activate p-type semiconductor layer 23.

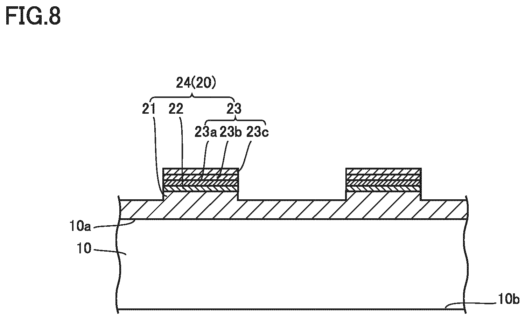

Mesa structure forming step S3 is performed after semiconductor layer forming step S2. Fig. 8 is a cross-sectional view illustrating mesa structure forming step S3. As shown in Fig. 8, in mesa structure forming step S3, mesa structure 24 is formed in semiconductor layer 20. In mesa structure forming step S3, firstly, a mask is formed on semiconductor layer 20. The mask is formed, for example, of a metal material such as nickel. Secondly, anisotropic etching is performed using the above-mentioned mask. Thereby, mesa structure 24 is formed. Thirdly, the mask is removed.

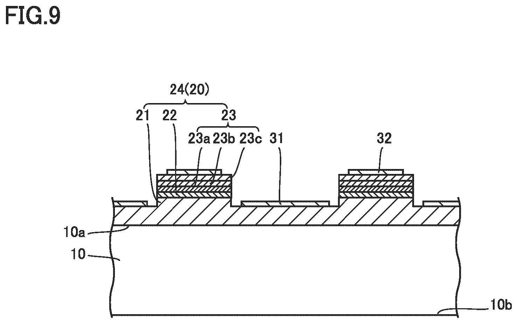

First electrode forming step S4 is performed after mesa structure forming step S3. Fig. 9 is a cross-sectional view illustrating first electrode forming step S4. As shown in Fig. 9, in first electrode forming step S4, n-electrode 31 and p-electrode 32 are formed. In first electrode forming step S4, n-electrode 31 and p-electrode 32 are sequentially formed, for example, by a vacuum deposition method. After n-electrode 31 and p-electrode 32 are formed, annealing is performed.

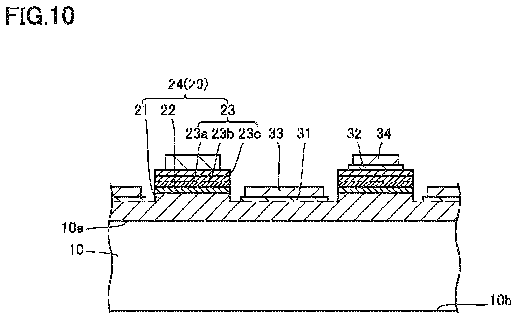

Second electrode forming step S5 is performed after first electrode forming step S4. Fig. 10 is a cross-sectional view illustrating second electrode forming step S5. As shown in Fig. 10, in second electrode forming step S5, pad electrodes 33 and 34 are formed. In second electrode forming step S5, pad electrodes 33 and 34 are formed, for example, by a vacuum deposition method.

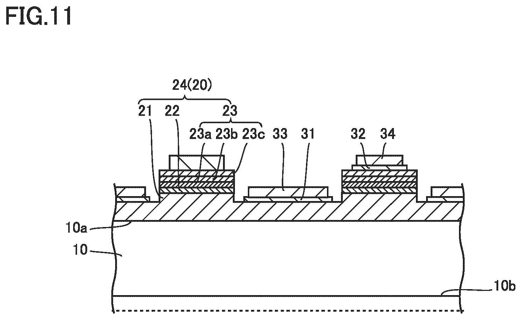

Substrate back surface processing step S6 is performed after second electrode forming step S5. Fig. 11 is a cross-sectional view illustrating substrate back surface processing step S6. As shown in Fig. 11, in substrate back surface processing step S6, second main surface 10b is machined (ground and polished). Thereby, substrate 10 is reduced in thickness.

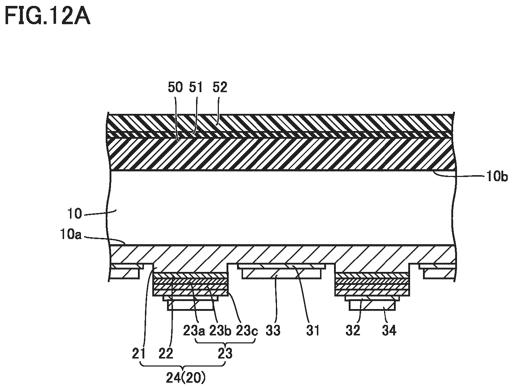

Mask forming step S7 is performed after substrate back surface processing step S6. Fig. 12A is a first cross-sectional view illustrating mask forming step S7. As shown in Fig. 12A, in mask forming step S7, firstly, a first layer 50, a second layer 51, and a third layer 52 are sequentially formed on second main surface 10b. In other words, first layer 50 is formed on second main surface 10b, second layer 51 is formed on first layer 50, and third layer 52 is formed on second layer 51.

The constituent material of first layer 50 is, for example, a resist. First layer 50 is formed, for example, by applying the constituent material of first layer 50 on second main surface 10b by a spin coating method, and then, baking and curing the applied constituent material of first layer 50. The constituent material of second layer 51 includes, for example, an inorganic material such as silicon dioxide. Second layer 51 is formed, for example, by applying the constituent material of second layer 51 on first layer 50 by a spin coating method, and then, baking and curing the applied constituent material of second layer 51. Second layer 51 may be a spin-on-glass (SOG) layer.

The constituent material of third layer 52 is, for example, a resist. Third layer 52 is formed, for example, by applying the constituent material of third layer 52 on second layer 51 by a spin coating method, and then, baking and curing the applied constituent material of third layer 52. First layer 50 is thicker, for example, than each of second layer 51 and third layer 52. Third layer 52 is thicker, for example, than second layer 51.

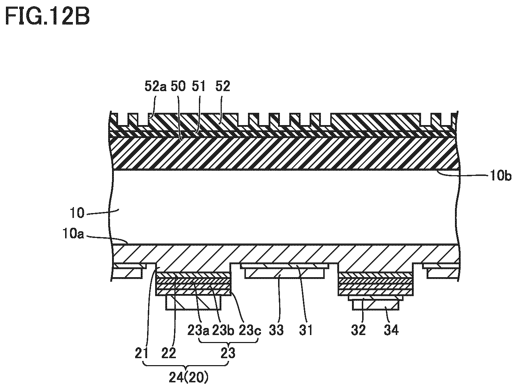

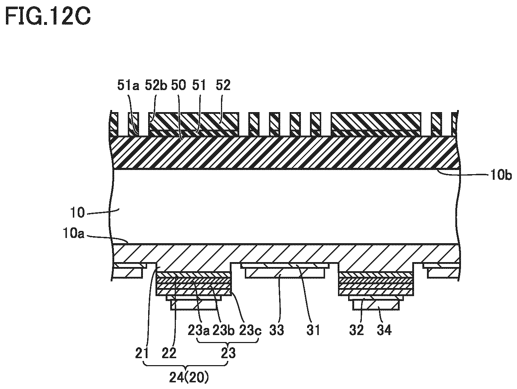

Fig. 12B is a second cross-sectional view illustrating mask forming step S7. As shown in Fig. 12B, in mask forming step S7, a recess 52a is secondly formed. Recess 52a is formed, for example, by pressing a mold against third layer 52, the mold having a protrusion at a position corresponding to recess 52a. At this time, the position of the protrusion in the mold (the position where recess 52a is formed) is aligned with mesa structure 24 located on the first main surface 10a side. This alignment is performed by a see-through inspection of an alignment mark and the shape of mesa structure 24 from the second main surface 10b side with use of an apparatus capable of achieving a double-sided alignment. This alignment may be performed with respect to an edge of substrate 10. Fig. 12C is a third cross-sectional view illustrating mask forming step S7. As shown in Fig. 12C, in mask forming step S7, an opening 51a is thirdly formed in second layer 51, for example, by performing anisotropic etching. By performing anisotropic etching, a portion of third layer 52 that is located at the bottom of recess 52a is removed to thereby form an opening 52b from recess 52a, and a portion of second layer 51 that is exposed from opening 52b is removed to thereby form opening 51a.

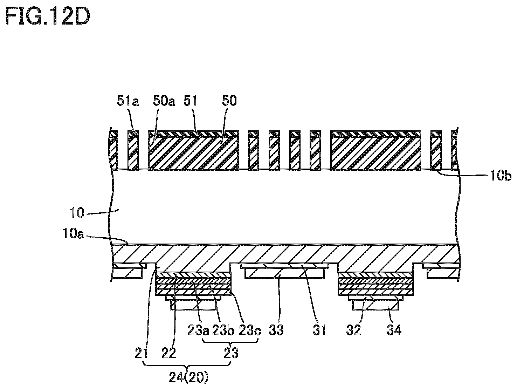

Fig. 12D is a fourth cross-sectional view illustrating mask forming step S7. As shown in Fig. 12D, in mask forming step S7, an opening 50a is fourthly formed, for example, by performing anisotropic etching. By performing anisotropic etching, a portion of first layer 50 that is exposed from opening 51a is removed to thereby form opening 50a. Further, third layer 52 is also removed by anisotropic etching. This results in formation of a mask including first layer 50 having opening 50a and second layer 51 having opening 51a.

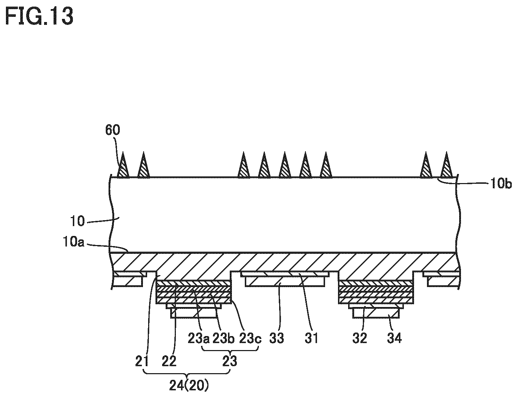

Columnar structure forming step S8 is performed after mask forming step S7. Fig. 13 is a cross-sectional view showing columnar structure forming step S8. As shown in Fig. 13, in columnar structure forming step S8, a columnar structure 60 is formed. The constituent material of columnar structure 60 is, for example, a metal material such as nickel. Columnar structure 60 has a shape corresponding to uneven structure 10c.

In columnar structure forming step S8, firstly, columnar structure 60 is formed by a vacuum deposition method on second main surface 10b exposed from openings 50a and 51a. At this time, a layer made of the same material as the material of columnar structure 60 is formed also on second layer 51. Secondly, first layer 50 is lifted off from second main surface 10b together with second layer 51 and the layer formed on second layer 51 and made of the same material as the material of columnar structure 60. Such lifting off is performed by immersing substrate 10 in an organic solvent such as acetone or N-methyl-2-pyrrolidone (NMP) and applying ultrasonic waves to substrate 10.

Uneven structure forming step S9 is performed after mask forming step S7. In uneven structure forming step S9, anisotropic etching is performed using columnar structure 60 as a mask. Thereby, the shape of uneven structure 10c is transferred onto second main surface 10b, and thus, uneven structure 10c is formed on second main surface 10b. Singulating step S10 is performed after uneven structure forming step S9. In singulating step S10, dicing is performed for singulation to produce a plurality of semiconductor light-emitting elements 100. Thereby, semiconductor light-emitting element 100 having the structure shown in Figs. 1 to 3 is manufactured.

### <Effects of Semiconductor Light-Emitting Element 100>

The following describes the effects of semiconductor light-emitting element 100 in comparison with a semiconductor light-emitting element according to a comparative example. The semiconductor light-emitting element according to Comparative Example 1 is referred to as a semiconductor light-emitting element 100A. The semiconductor light-emitting element according to Comparative Example 2 is referred to as a semiconductor light-emitting element 100B.

In semiconductor light-emitting element 100A, second main surface 10b is entirely configured as a flat surface. Other than this point, the configuration of semiconductor light-emitting element 100A is the same as that of semiconductor light-emitting element 100. In semiconductor light-emitting element 100A, second main surface 10b is configured as a flat surface, and anti-reflection film 40 is disposed on second main surface 10b. In semiconductor light-emitting element 100B, uneven structure 10c is formed on the entirety of second main surface 10b. Other than these points, the configuration of semiconductor light-emitting element 100B is the same as that of semiconductor light-emitting element 100.

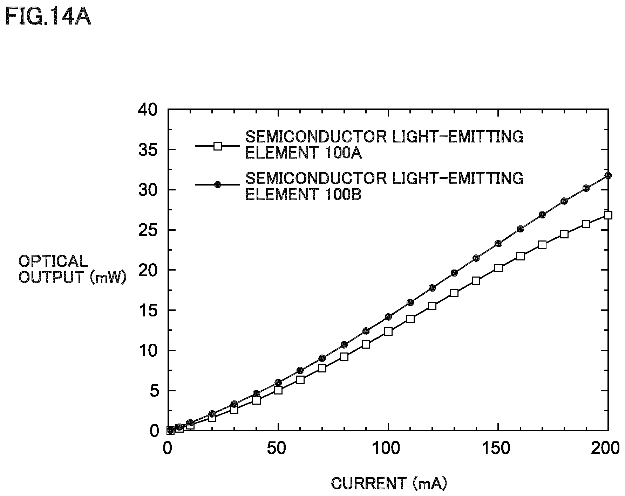

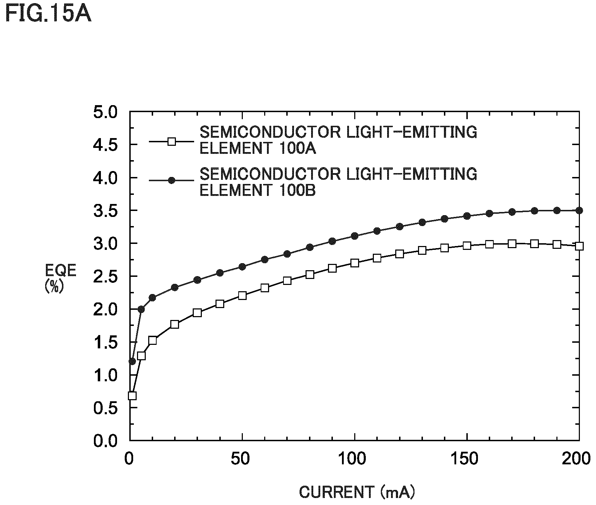

Fig. 14A is a graph showing the relation between a current and an optical output in each of semiconductor light-emitting elements 100A and 100B. As shown in Fig. 14A, the optical output of semiconductor light-emitting element 100B is larger than the optical output of semiconductor light-emitting element 100A. More specifically, when a current of 200 mA flows, the optical output of semiconductor light-emitting element 100B is 1.18 times as large as the optical output of semiconductor light-emitting element 100A. Fig. 15A is a graph showing the relation between a current and external quantum efficiency in each of semiconductor light-emitting elements 100A and 100B. As shown in Fig. 15A, the external quantum efficiency (EQE) of semiconductor light-emitting element 100B is higher than that of semiconductor light-emitting element 100A. More specifically, when a current of 200 mA flows, the external quantum efficiency of semiconductor light-emitting element 100B is 1.18 times as large as that of semiconductor light-emitting element 100A.

Based on the above-mentioned comparisons, in semiconductor light-emitting element 100A, deep ultraviolet light can be extracted only from the portion of second main surface 10b that faces mesa structure 24, whereas, in semiconductor light-emitting element 100B in which uneven structure 10c is formed on second main surface 10b, deep ultraviolet light can be extracted also from the portion of second main surface 10b that does not face mesa structure 24. Therefore, semiconductor light-emitting element 100B is improved in extraction efficiency for deep ultraviolet light as compared with semiconductor light-emitting element 100A.

According to the finding that has been newly revealed, however, in semiconductor light-emitting element 100B, uneven structure 10c is formed on the entirety of second main surface 10b including first region 10ba, with the result that part of the deep ultraviolet light extracted from first region 10ba is diffracted or scattered by uneven structure 10c located in first region 10ba, and thereby, the extraction efficiency for deep ultraviolet light in first region 10ba decreases.

In semiconductor light-emitting element 100, based on the above-mentioned finding, first region 10ba is configured as a flat surface. In other words, in semiconductor light-emitting element 100, uneven structure 10c is not formed in first region 10ba. Thus, in semiconductor light-emitting element 100, uneven structure 10c is formed in second region 10bb to enable extraction of the deep ultraviolet light from the portion of second main surface 10b that does not face mesa structure 24, and also, first region 10ba is configured as a flat surface to suppress diffraction and scattering of the deep ultraviolet light in the portion of second main surface 10b that faces mesa structure 24, with the result that the extraction efficiency for light ultraviolet light is enhanced.

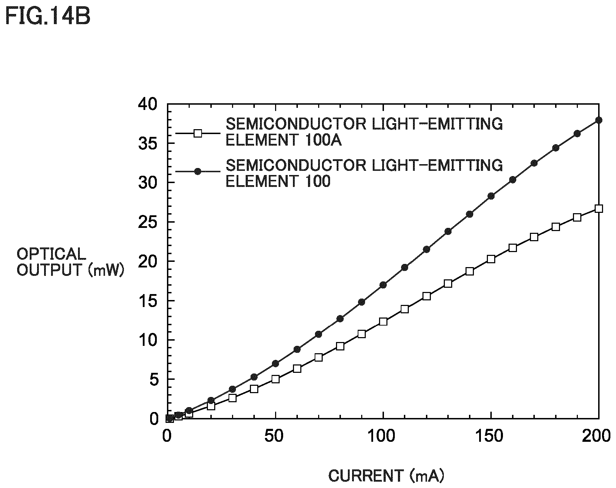

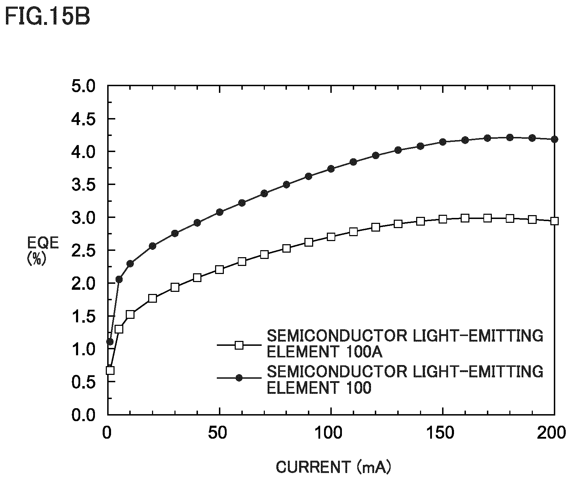

Fig. 14B is a graph showing the relation between the current and the optical output in each of semiconductor light-emitting elements 100 and 100A. Fig. 15B is a graph showing the relation between the current and the external quantum efficiency in each of semiconductor light-emitting elements 100 and 100B. As shown in Figs. 14B and 15B, semiconductor light-emitting element 100 is improved in extraction efficiency for deep ultraviolet light (the optical output, the external quantum efficiency) as compared with semiconductor light-emitting element 100B. More specifically, when a current of 200 mA flows, the optical output and the external quantum efficiency of semiconductor light-emitting element 100 are 1.42 times as large as those of semiconductor light-emitting element 100A. This also supports that semiconductor light-emitting element 100 enables enhancement of the extraction efficiency for deep ultraviolet light.

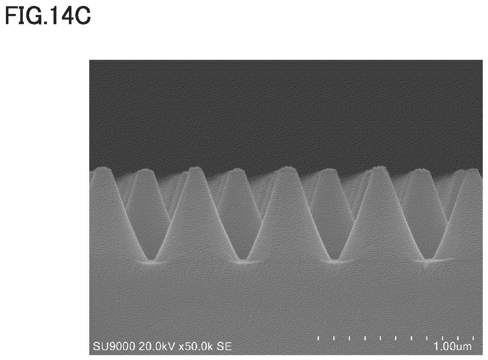

In Figs. 14A, 14B, 15A, and 15B, width W1 is 90 µm, the chip size of the semiconductor light-emitting element is 1 mm × 1 mm, and the area of mesa structure 24 in a plan view is 0.30 mm². Further, in Figs. 14B and 15B, in semiconductor light-emitting element 100, width W2 is 110 µm, and anti-reflection film 40 is disposed on first region 10ba. Fig. 14C is an exemplary cross-sectional SEM image of semiconductor light-emitting elements 100 and 100B. In Figs. 14B and 14C, in each of semiconductor light-emitting elements 100 and 100B, as shown in Fig. 14C, uneven structure 10c includes conical protrusions each having an aspect ratio of 1.0, the period of uneven structure 10c is 600 nm, and the protrusions included in uneven structure 10c are arranged in a triangular lattice pattern in a plan view.

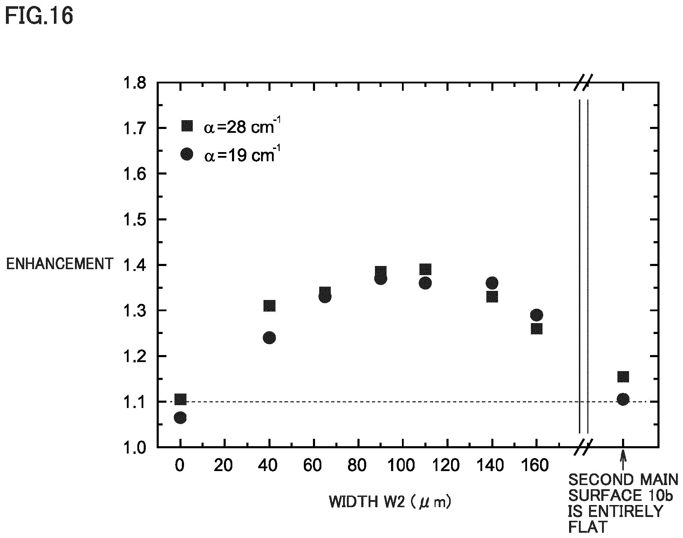

Fig. 16 is a graph showing the relation between width W2 and enhancement in semiconductor light-emitting element 100. In Fig. 16, in semiconductor light-emitting element 100, width W1 is 90 µm, anti-reflection film 40 is disposed on first region 10ba, thickness T is 100 µm, and the absorption coefficient of substrate 10 is 28 cm⁻¹ or 19 cm⁻¹. In Fig. 16, the enhancement of semiconductor light-emitting element 100 is the rate of improvement in the optical output with respect to semiconductor light-emitting element 100A, i.e., the rate of improvement in the light extraction efficiency. As shown in Fig. 16, when width W2 is 40 µm or more and 160 µm or less (i.e., when width W2 is 0.4 times or more and 1.8 times or less as large as width W1), the rate of improvement (enhancement) in the extraction efficiency for deep ultraviolet light is particularly improved.

Further, it turns out that, in semiconductor light-emitting element 100, the extraction efficiency for deep ultraviolet light is further improved when width W2 is 60 µm or more and 140 µm or less (width W2 is 0.8 times or more and 1.5 times or less as large as width W1), and also, the extraction efficiency for deep ultraviolet light is still further improved when width W2 is 90 µm or more and 110 µm or less (width W2 is 1.0 times or more and 1.25 times or less as large as width W1).

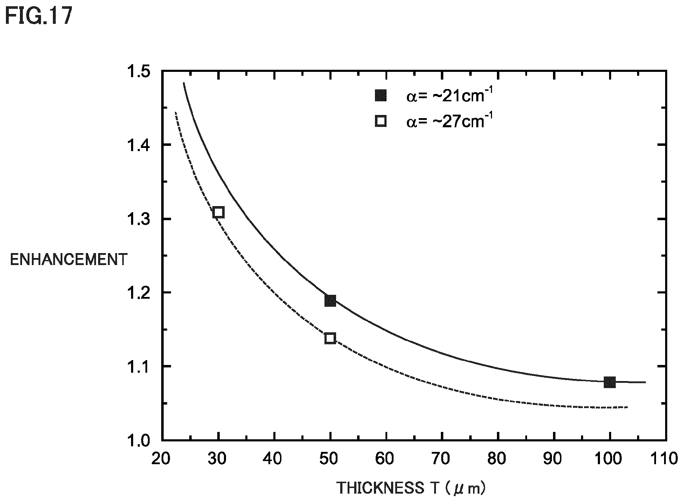

Fig. 17 is a graph showing the relation between thickness T and the enhancement in semiconductor light-emitting element 100B. When substrate 10 having a large absorption coefficient like an aluminum nitride substrate formed by the PVT method is used, semiconductor light-emitting element 100B can be enhanced in extraction efficiency for deep ultraviolet light with smaller thickness T, but is decreased in extraction efficiency for deep ultraviolet light with larger thickness T (for example, 100 µm), as shown in Fig. 17. On the other hand, in semiconductor light-emitting element 100, high extraction efficiency for deep ultraviolet light can be maintained even when substrate 10 having a large absorption coefficient and having a larger thickness T (for example, 100 µm) is used (see Fig. 16). Being able to use substrate 10 having large thickness T means that the handleability of substrate 10 during manufacturing is improved.

### (Second Embodiment)

The following describes a semiconductor light-emitting element (referred to as a semiconductor light-emitting element 200) according to the second embodiment. In the following, differences from semiconductor light-emitting element 100 will be mainly described, and redundant description will not be repeated.

### <Configuration of Semiconductor Light-Emitting Element 200>

The following describes a configuration of semiconductor light-emitting element 200.

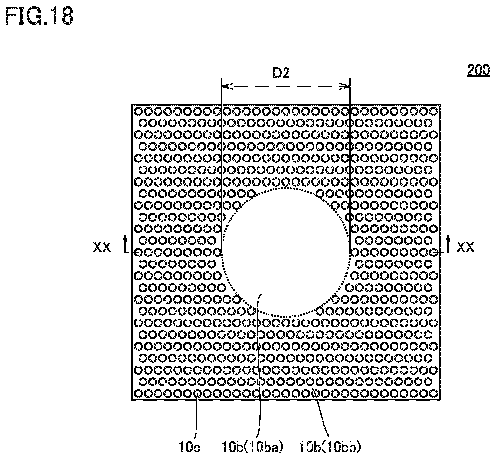

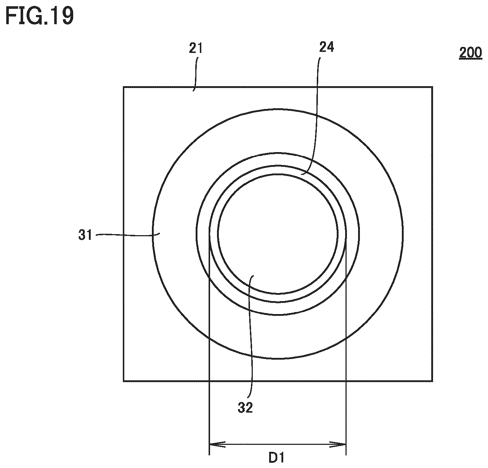

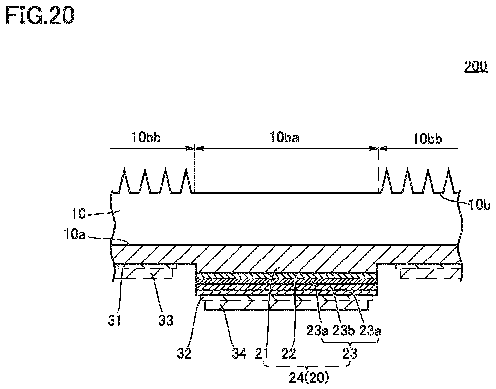

Fig. 18 is a plan view of semiconductor light-emitting element 200. Fig. 19 is a plan view of semiconductor light-emitting element 200 as viewed from the side opposite to that shown in Fig. 18. Fig. 19 does not show pad electrodes 33 and 34. Fig. 20 is a cross-sectional view taken along XX-XX in Fig. 18. As shown in Figs. 18 to 20, semiconductor light-emitting element 200 includes substrate 10, semiconductor layer 20, n-electrode 31, p-electrode 32, pad electrode 33, and pad electrode 34. In this respect, the configuration of semiconductor light-emitting element 200 is the same as that of semiconductor light-emitting element 100.

In semiconductor light-emitting element 200, mesa structure 24 and first region 10ba are circular in a plan view. In a plan view, the center of first region 10ba preferably overlaps with the region of mesa structure 24. The diameter of mesa structure 24 in a plan view is defined as a diameter D1. In a plan view, with respect to the center of first region 10ba, the distance between the center of mesa structure 24 and first region 10ba is preferably 0.2 times or less as large as diameter D1, and more preferably 0.05 times or less as large as diameter D1. In a plan view, the center of mesa structure 24 most preferably coincides with the center of first region 10ba. The diameter of first region 10ba in a plan view is defined as a diameter D2. Diameter D2 is preferably 0.1 times or more as large as diameter D1, and preferably 0.5 times or more and 3.0 times or less as large as diameter D1. The lower limit of diameter D2 is preferably 0.9 times or 1.0 times as large as diameter D1. The upper limit of diameter D2 is preferably 2.5 times, 1.5 times, or 1.25 times as large as diameter D1. In these respects, the configuration of semiconductor light-emitting element 200 is different from that of semiconductor light-emitting element 100.

### <Modifications>

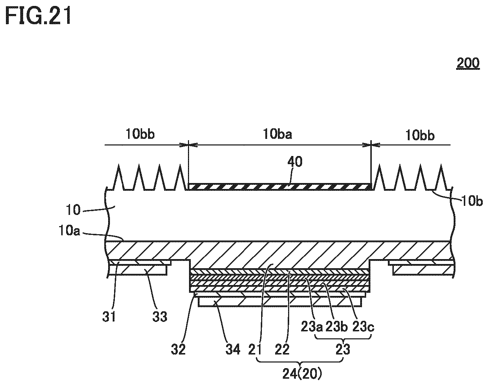

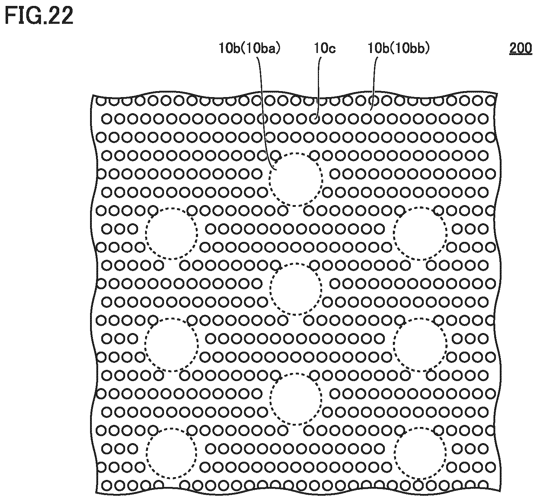

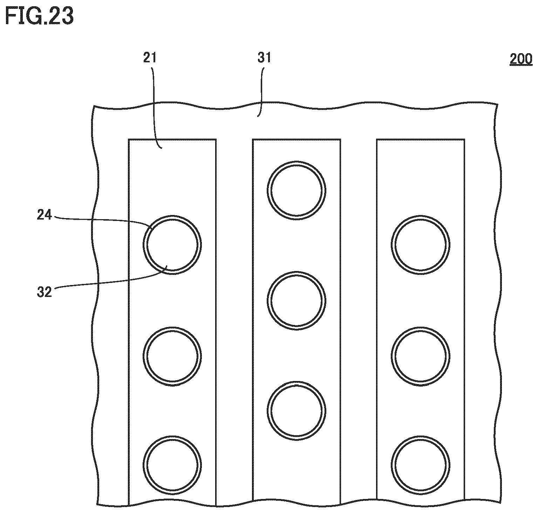

Fig. 21 is a cross-sectional view of a semiconductor light-emitting element 200 according to the first modification. As shown in Fig. 21, semiconductor light-emitting element 200 may further include anti-reflection film 40 disposed on first region 10ba. Fig. 22 is a plan view of a semiconductor light-emitting element 200 according to the second modification. Fig. 23 is a plan view of semiconductor light-emitting element 200 according to the second modification as viewed from the side opposite to that shown in Fig. 22. As shown in Figs. 22 and 23, in semiconductor light-emitting element 200, each of mesa structure 24 and first region10ba may be more than one in number.

### <Effects of Semiconductor Light-Emitting Element 200>

The following describes the effects of semiconductor light-emitting element 200 in comparison with a semiconductor light-emitting element according to Comparative Example 3, a semiconductor light-emitting element according to Comparative Example 4, and a semiconductor light-emitting element according to Comparative Example 5. The semiconductor light-emitting element according to Comparative Example 3 is referred to as a semiconductor light-emitting element 200A, the semiconductor light-emitting element according to Comparative Example 4 is referred to as a semiconductor light-emitting element 200B, and the semiconductor light-emitting element according to Comparative Example 5 is referred to as a semiconductor light-emitting element 200C.

In semiconductor light-emitting elements 200A and 200C, second main surface 10b is entirely configured as a flat surface. Other than this point, the configuration of each of semiconductor light-emitting elements 200A and 200C is the same as that of semiconductor light-emitting element 200. In semiconductor light-emitting element 200C, anti-reflection film 40 is disposed on second main surface 10b. In semiconductor light-emitting element 200B, uneven structure 10c is formed on the entirety of second main surface 10b. Other than this point, the configuration of semiconductor light-emitting element 200B is the same as that of semiconductor light-emitting element 200.

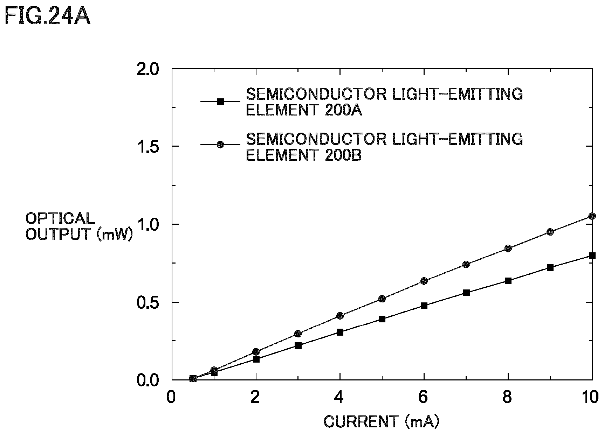

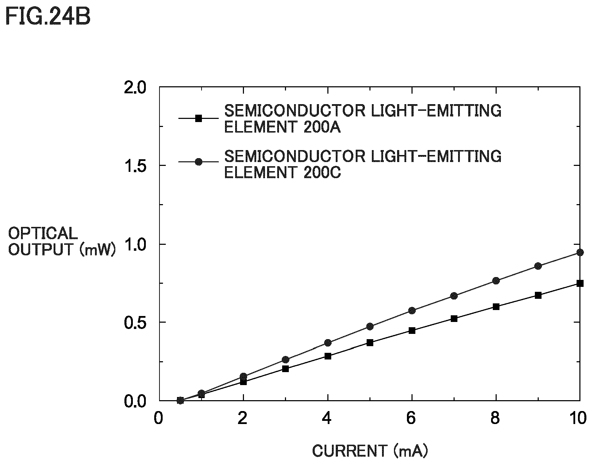

Fig. 24A is a graph showing the relation between the current and the optical output in each of semiconductor light-emitting elements 200A and 200B. As shown in Fig. 24A, the optical output of semiconductor light-emitting element 200B is larger than that of semiconductor light-emitting element 200A. More specifically, when a current of 8 mA flows, the optical output of semiconductor light-emitting element 200B is 1.33 times as large as that of semiconductor light-emitting element 200A. Fig. 24B is a graph showing the relation between the current and the optical output in each of semiconductor light-emitting elements 200A and 200C. As shown in Fig. 24B, the optical output of semiconductor light-emitting element 200C is higher than that of semiconductor light-emitting element 200A. More specifically, when a current of 8 mA flows, the optical output of semiconductor light-emitting element 200C is 1.27 times as large as that of semiconductor light-emitting element 200A.

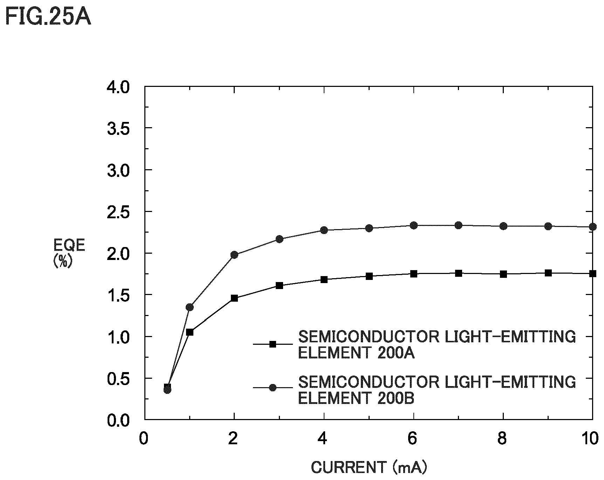

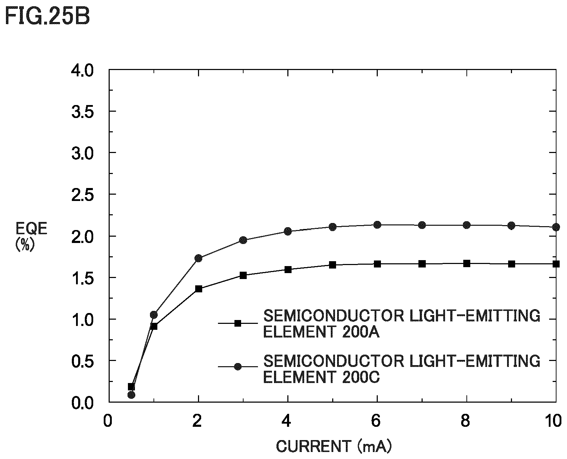

Fig. 25A is a graph showing the relation between a current and external quantum efficiency in each of semiconductor light-emitting elements 200A and 200B. As shown in Fig. 25A, the external quantum efficiency of semiconductor light-emitting element 200B is higher than that of semiconductor light-emitting element 200A. More specifically, when a current of 8 mA flows, the external quantum efficiency of semiconductor light-emitting element 200B is 1.33 times as large as that of semiconductor light-emitting element 200A. Fig. 25B is a graph showing the relation between the current and the external quantum efficiency in each of semiconductor light-emitting elements 200A and 200C. As shown in Fig. 25B, the external quantum efficiency of semiconductor light-emitting element 200C is higher than that of semiconductor light-emitting element 200A. More specifically, when a current of 8 mA flows, the external quantum efficiency of semiconductor light-emitting element 200C is 1.27 times as large as that of semiconductor light-emitting element 200A.

From the comparisons described above, in each of semiconductor light-emitting elements 200A and 200C, deep ultraviolet light can be extracted only from the portion of second main surface 10b that faces mesa structure 24, whereas, in semiconductor light-emitting element 200B in which uneven structure 10c is formed on second main surface 10b, deep ultraviolet light can be extracted also from the portion of second main surface 10b that does not face mesa structure 24. Therefore, semiconductor light-emitting element 200B is improved in extraction efficiency for deep ultraviolet light as compared with semiconductor light-emitting elements 200A and 200C.

However, in semiconductor light-emitting element 200B, uneven structure 10c is formed on the entirety of second main surface 10b including first region 10ba, with the result that part of the deep ultraviolet light extracted from first region 10ba is diffracted or scattered by uneven structure 10c located in first region 10ba. In semiconductor light-emitting element 200, uneven structure 10c is formed in second region 10bb to enable extraction of deep ultraviolet light from the portion of second main surface 10b that does not face mesa structure 24, while first region 10ba is configured as a flat surface to suppress diffraction and scattering of deep ultraviolet light in the portion of second main surface 10b that faces mesa structure 24, with the result that the extraction efficiency for light ultraviolet light is enhanced.

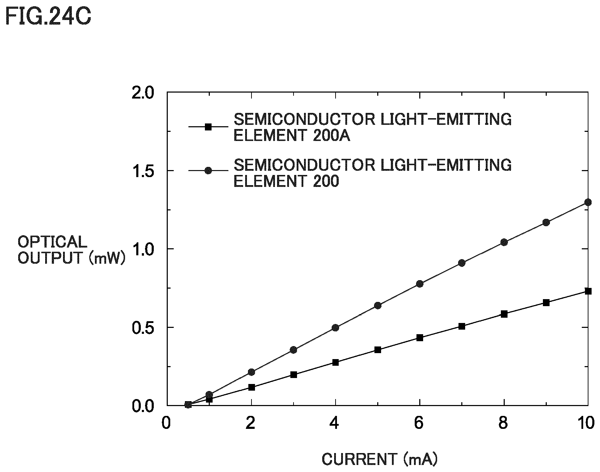

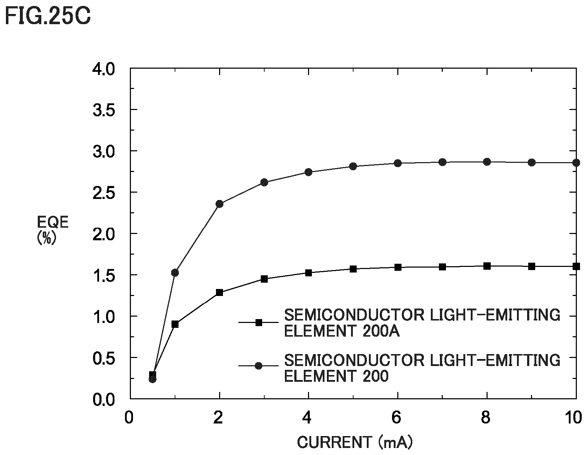

Fig. 24C is a graph showing the relation between the current and the optical output in each of semiconductor light-emitting elements 200 and 200A. Fig. 25C is a graph showing the relation between the current and the external quantum efficiency in each of semiconductor light-emitting elements 200 and 200B. As shown in Figs. 24C and 25C, semiconductor light-emitting element 200 is improved in extraction efficiency for the deep ultraviolet light (the optical output, the external quantum efficiency) as compared with semiconductor light-emitting element 200B. More specifically, when a current of 8 mA flows, the optical output and the external quantum efficiency of semiconductor light-emitting element 100 are 1.78 times as high as those of semiconductor light-emitting element 200A. This comparison supports that semiconductor light-emitting element 200 enables enhancement of the extraction efficiency for deep ultraviolet light.

In Figs. 24A, 24B, 24C, 25A, 25B, and 25C, diameter D1 is 100 µm. In Figs. 24C and 25C, in semiconductor light-emitting element 200, diameter D2 is 120 µm, and anti-reflection film 40 is disposed on first region 10ba. In Figs. 24A, 24C, 25A, and 25B, in each of semiconductor light-emitting elements 200 and 200B, uneven structure 10c includes conical protrusions each having an aspect ratio of 1.0, the period of uneven structure 10c is 600 nm, and the protrusions included in uneven structure 10c are arranged in a triangular lattice pattern in a plan view.

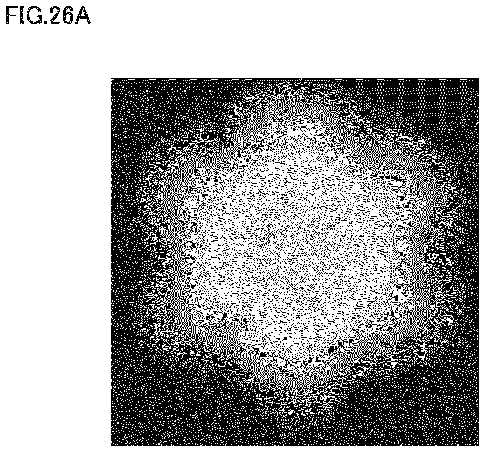

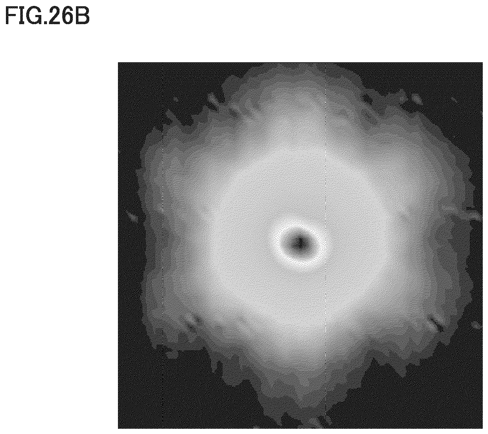

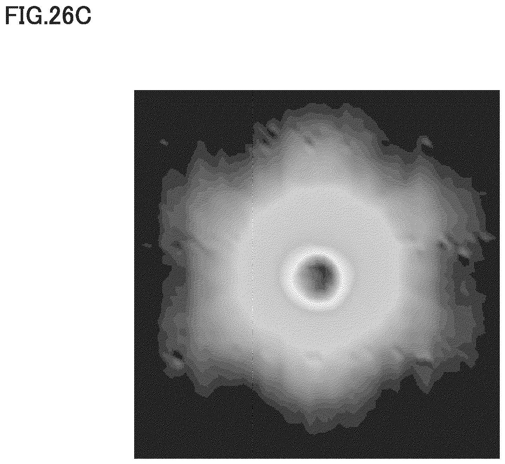

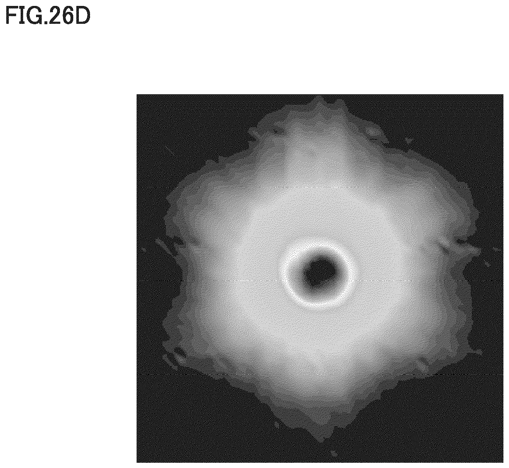

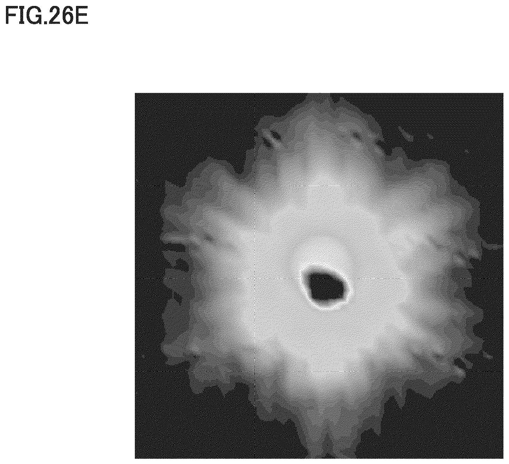

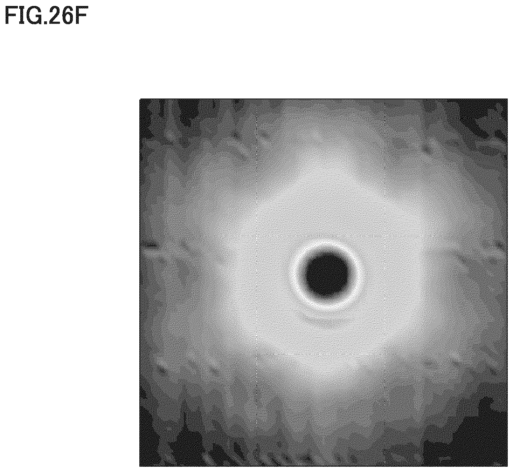

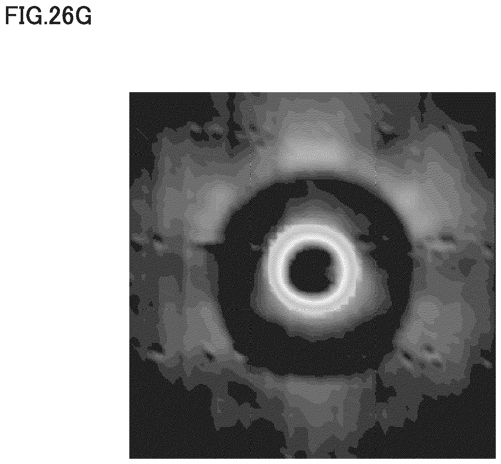

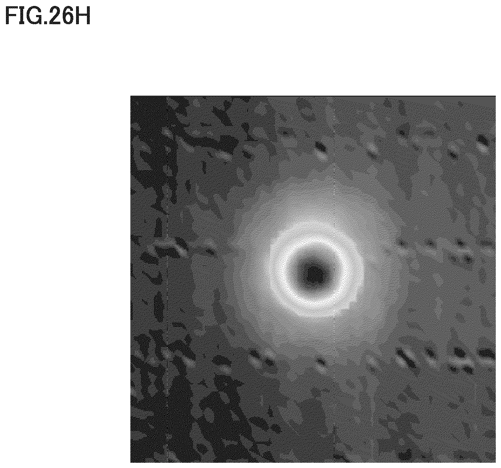

Fig. 26A shows a result of a near field pattern (NFP) analysis in semiconductor light-emitting element 200B. Fig. 26B shows an NFP analysis of semiconductor light-emitting element 200 on condition that diameter D2 is 50 µm. Fig. 26C shows a result of the NFP analysis of semiconductor light-emitting element 200 on condition that diameter D2 is 80 µm. Fig. 26D shows a result of the NFP analysis of semiconductor light-emitting element 200 on condition that diameter D2 is 100 µm. Fig. 26E shows a result of the NFP analysis of semiconductor light-emitting element 200 on condition that diameter D2 is 120 µm. Fig. 26F shows a result of the NFP analysis of semiconductor light-emitting element 200 on condition that diameter D2 is 150 µm. Fig. 26G shows a result of the NFP analysis of semiconductor light-emitting element 200 on condition that diameter D2 is 300 µm. Fig. 26H shows a result of the NFP analysis of semiconductor light-emitting element 200C. In Figs. 26A to 26G, diameter D1 is 100 µm.

As shown in Fig. 26H, in semiconductor light-emitting element 200C, deep ultraviolet light is extracted only from a portion of second main surface 10b that faces mesa structure 24 (see a black region in a center portion in Fig. 26H). As shown in Fig. 26A, in semiconductor light-emitting element 200B, deep ultraviolet light can be extracted also from a portion of second main surface 10b that does not face mesa structure 24, but the intensity of the deep ultraviolet light extracted from the portion of second main surface 10b that faces mesa structure 24 is weak (Fig. 26A does not include a black region in the center portion, unlike Fig. 26H). In Figs. 26A to 26H, there is a black region other than in the center portion, but the intensity of the deep ultraviolet light is weakest in the black region other than in the center portion.

On the other hand, as shown in Figs. 26B to 26G, in semiconductor light-emitting element 200, the deep ultraviolet light can be extracted from the portion of second main surface 10b that does not face mesa structure 24, and the intensity of the deep ultraviolet light extracted from the portion of second main surface 10b that faces mesa structure 24 is strong. These comparisons also support that the deep ultraviolet light can be extracted from the portion of second main surface 10b that does not face mesa structure 24 while enabling suppression of diffraction and scattering of the deep ultraviolet light in the portion of second main surface 10b that faces mesa structure 24.

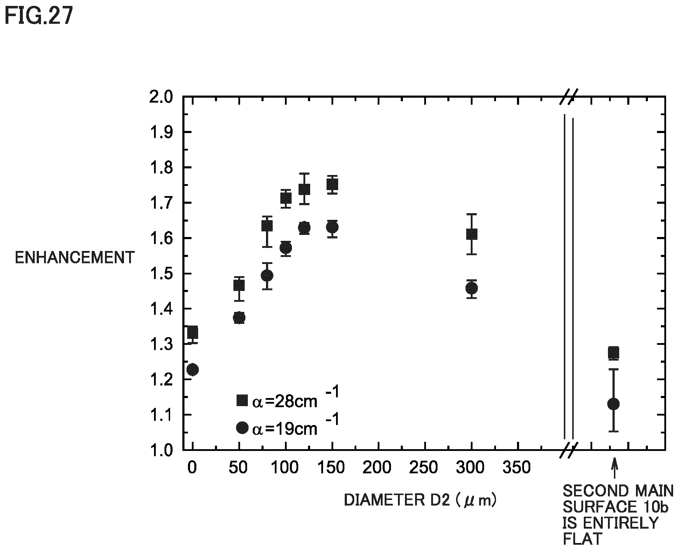

Fig. 27 is a graph showing the relation between diameter D2 and the enhancement in semiconductor light-emitting element 200. In Fig. 27, in semiconductor light-emitting element 200, width W1 is 100 µm, anti-reflection film 40 is disposed on first region 10ba, thickness T is 100 µm, and the absorption coefficient of substrate 10 is 28 cm⁻¹ or 19 cm⁻¹. In Fig. 27, the enhancement of semiconductor light-emitting element 200 is the rate of improvement in the optical output with respect to semiconductor light-emitting element 200A, i.e., the rate of improvement in the light extraction efficiency. As shown in Fig. 27, when diameter D2 is 50 µm or more and 300 µm or less (i.e., when diameter D2 is 0.5 times or more and 3.0 times or less as large as diameter D1), the extraction efficiency (enhancement) for deep ultraviolet light is particularly improved.

Further, it turns out that, in semiconductor light-emitting element 200, the extraction efficiency for deep ultraviolet light is further improved when diameter D2 is 80 µm or more and 150 µm or less (width W2 is 0.8 times or more and 1.5 times or less as large as width W1), and the extraction efficiency for deep ultraviolet light is further improved when diameter D2 is 100 µm or more and 125 µm or less (diameter D2 is 1.0 times or more and 1.25 times or less as large as diameter D1).

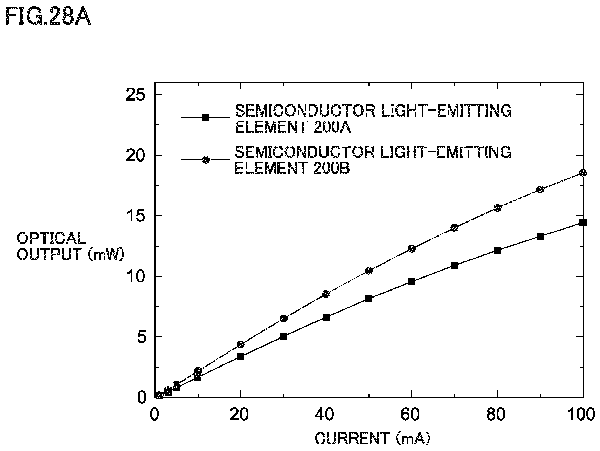

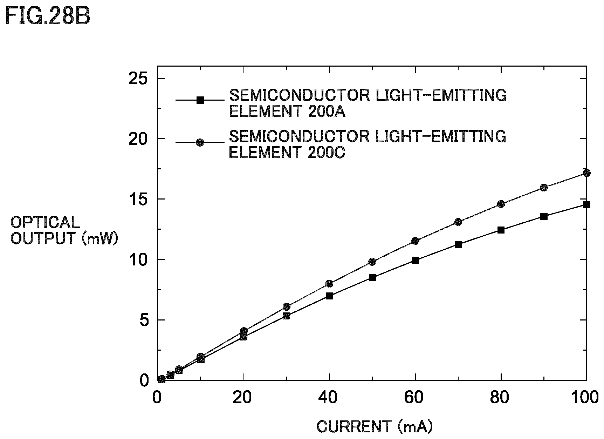

Fig. 28A is a graph showing the relation between the current and the optical output in each of semiconductor light-emitting elements 200A and 200B on condition that mesa structure 24 is more than one in number. As shown in Fig. 28A, when mesa structure 24 is more than one in number, the optical output of semiconductor light-emitting element 200B is larger than that of semiconductor light-emitting element 200A. More specifically, when a current of 100 mA flows, the optical output of semiconductor light-emitting element 200B is 1.29 times as large as that of semiconductor light-emitting element 200A. Fig. 28B is a graph showing the relation between the current and the optical output in each of semiconductor light-emitting elements 200A and 200C on condition that mesa structure 24 is more than one in number. As shown in Fig. 28B, when mesa structure 24 is more than one in number, the optical output of semiconductor light-emitting element 200C is higher than that of semiconductor light-emitting element 200A. More specifically, when a current of 100 mA flows, the optical output of semiconductor light-emitting element 200C is 1.18 times as large as that of semiconductor light-emitting element 200A.

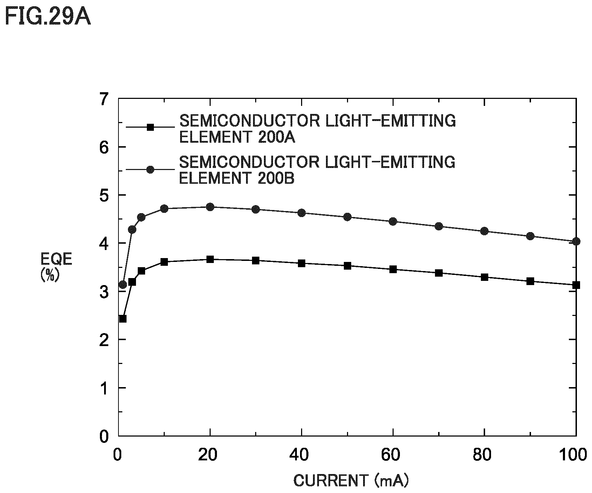

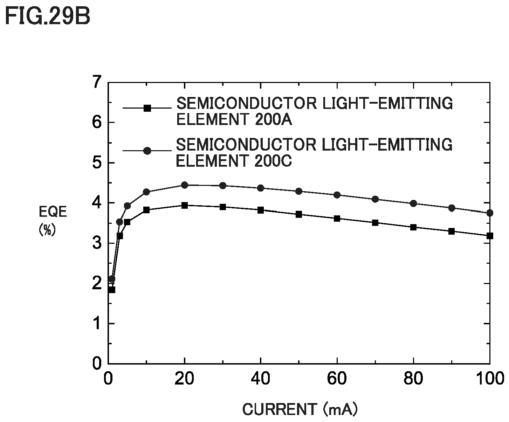

Fig. 29A is a graph showing the relation between the current and the external quantum efficiency in each of semiconductor light-emitting elements 200A and 200B on condition that mesa structure 24 is more than one in number. As shown in Fig. 29A, when mesa structure 24 is more than one in number, the external quantum efficiency of semiconductor light-emitting element 200B is higher than that of semiconductor light-emitting element 200A. More specifically, when a current of 100 mA flows, the external quantum efficiency of semiconductor light-emitting element 200B is 1.29 times as high as that of semiconductor light-emitting element 200A. Fig. 29B is a graph showing the relation between the current and the external quantum efficiency in each of semiconductor light-emitting elements 200A and 200C on condition that mesa structure 24 is more than one in number. As shown in Fig. 29B, when mesa structure 24 is more than one in number, the external quantum efficiency of semiconductor light-emitting element 200C is higher than that of semiconductor light-emitting element 200A. More specifically, when a current of 100 mA flows, the external quantum efficiency of semiconductor light-emitting element 200C is 1.18 times as high as that of semiconductor light-emitting element 200A.

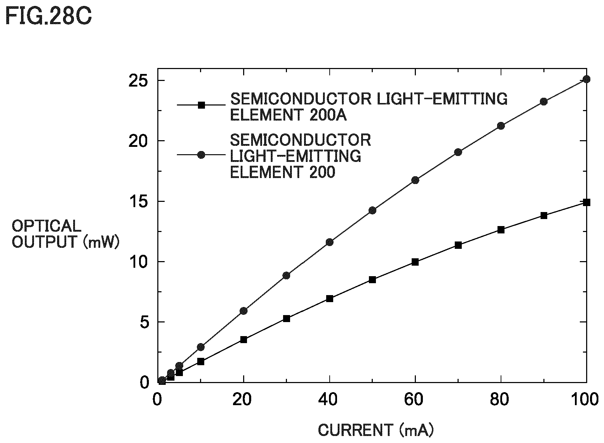

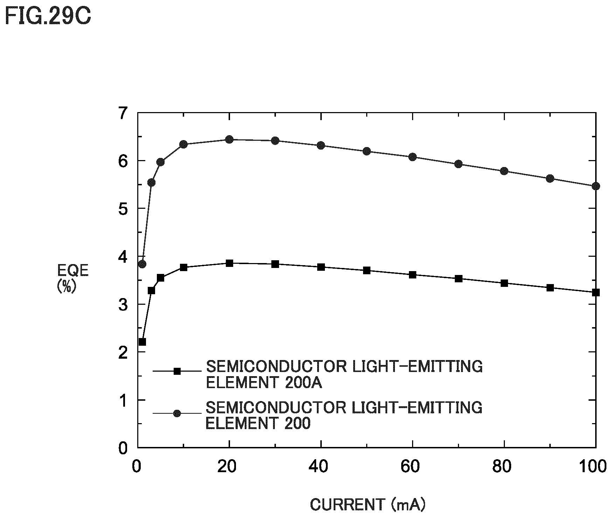

Fig. 28C is a graph showing the relation between the current and the optical output in each of semiconductor light-emitting elements 200 and 200A on condition that mesa structure 24 is more than one in number. Fig. 29C is a graph showing the relation between the current and the external quantum efficiency in each of semiconductor light-emitting elements 200 and 200B on condition that mesa structure 24 is more than one in number. In semiconductor light-emitting element 200, when mesa structure 24 is more than one in number, the extraction efficiency for deep ultraviolet light (the optical output, the external quantum efficiency) is improved as compared with semiconductor light-emitting element 200B, as shown in Figs. 28C and 29C. More specifically, when a current of 100 mA flows, the optical output and the external quantum efficiency of semiconductor light-emitting element 100 are 1.68 times as large as those of semiconductor light-emitting element 200A. This comparison supports that semiconductor light-emitting element 200 enables enhancement of the extraction efficiency for deep ultraviolet light also in the case where each of mesa structure 24 and first region 10ba is more than one in number.

In Figs. 28A, 28B, 28C, 29A, 29B, and 29C, diameter D1 is 100 µm, the chip size of the semiconductor light-emitting element is 2 mm × 2 mm, the pitch between two adjacent mesa structures 24 is 175 µm, a single crystal substrate made of aluminum nitride, having thickness T of 100 µm and having an absorption coefficient of 11 cm⁻¹ is used as substrate 10, and the total area of mesa structures 24 in a plan view is 0.778 mm². In Figs. 28C and 29C, in semiconductor light-emitting element 200, diameter D2 is 120 µm, and anti-reflection film 40 is disposed on first region 10ba.

### (Third Embodiment)

A semiconductor light-emitting element according to the third embodiment (referred to as a semiconductor light-emitting element 300) will be hereinafter described. In the following, differences from semiconductor light-emitting element 200 will be mainly described, and redundant description will not be repeated.

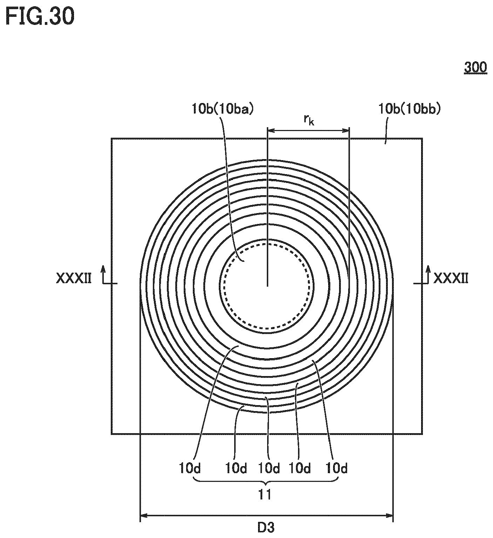

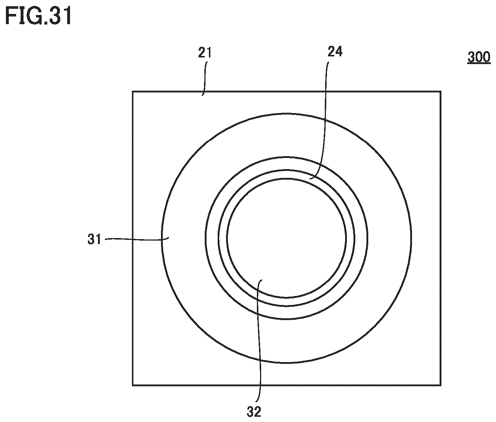

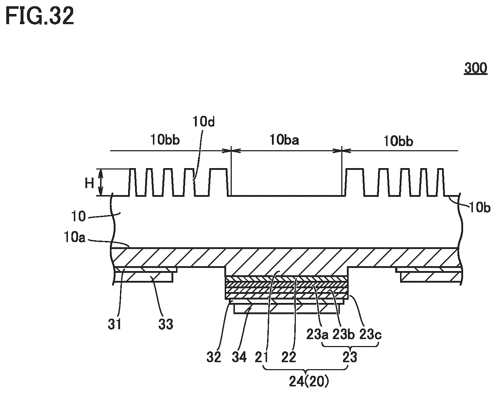

Fig. 30 is a plan view of semiconductor light-emitting element 300. Fig. 31 is a plan view of semiconductor light-emitting element 300 as viewed from the side opposite to that shown in Fig. 30. Fig. 31 does not show pad electrodes 33 and 34. Fig. 32 is a cross-sectional view taken along XXXII-XXXII in Fig. 30. As shown in Figs. 30 to 32, semiconductor light-emitting element 300 includes substrate 10, semiconductor layer 20, n-electrode 31, p-electrode 32, and pad electrodes 33 and 34. In this respect, the configuration of semiconductor light-emitting element 300 is the same as that of semiconductor light-emitting element 200.

In semiconductor light-emitting element 300, a plurality of annular protrusions 10d are formed as uneven structure 10c on second main surface 10b. The plurality of annular protrusions 10d are concentrically arranged at intervals. The plurality of annular protrusions 10d preferably constitute a Fresnel zone plate structure 11. The radius of the sidewall surface of the k-th (k is a natural number) annular protrusion 10d from the inner side in a plan view is defined as a radius rₖ. For example, the radius of the inner peripheral sidewall surface of the third annular protrusion 10d from the inner side is r₅, and the radius of the outer peripheral sidewall surface of the third annular protrusion 10d from the inner side is r₆.

In Fresnel zone plate structure 11, the relation with rₖ = (kλf + k²λ²/4)^{1/2} is satisfied. In this case, λ is a wavelength of the deep ultraviolet light generated from active layer 22, and f is a focal length. Further, f is preferably equal to thickness T.

In a plan view, the distance between the center of Fresnel zone plate structure 11 (the center of annular protrusion 10d) and the center of mesa structure 24 is preferably 0.05 times or less as large as diameter D1. In a plan view, the center of Fresnel zone plate structure 11 further preferably coincides with the center of mesa structure 24. The height of annular protrusion 10d is defined as a height H. Height H preferably satisfies the relation with nₐᵢᵣλ/2(n_{sub} - nₐᵢᵣ). In this case, nₐᵢᵣ is a refractive index of the deep ultraviolet light in air, and n_{sub} is a refractive index of the deep ultraviolet light in a substrate. Note that nₐᵢᵣ is 1. Further, in the case where the constituent material of substrate 10 is aluminum nitride, n_{sub} is 2.29. In the case where the constituent material of substrate 10 is sapphire, n_{sub} is 1.83. Thus, when λ is 265 nm and the constituent material of substrate 10 is aluminum nitride, height H is most preferably 103 nm.

Annular protrusion 10d preferably has a trapezoidal shape in a cross-sectional view orthogonal to the extending direction of annular protrusion 10d. In a cross-sectional view orthogonal to the extending direction of annular protrusion 10d, annular protrusion 10d may have a rectangular shape, a triangular shape, or a shape in which a rectangle and a trapezoid overlap. In a cross-sectional view orthogonal to the extending direction of annular protrusion 10d, an angle (a taper angle) formed between a side surface of annular protrusion 10d and a portion of second main surface 10b where annular protrusion 10d is not formed is preferably 50° or more, more preferably 65° or more, and particularly preferably 80° or more. The diameter of Fresnel zone plate structure 11 is defined as a diameter D3. D3 is preferably 3 times or more, 5 times or more, 10 times or more, or 20 times or more as large as diameter D1. In these respects, the configuration of semiconductor light-emitting element 300 is different from that of semiconductor light-emitting element 200. Although not shown, anti-reflection film 40 may be disposed on first region 10ba also in semiconductor light-emitting element 300.

### <Modifications>

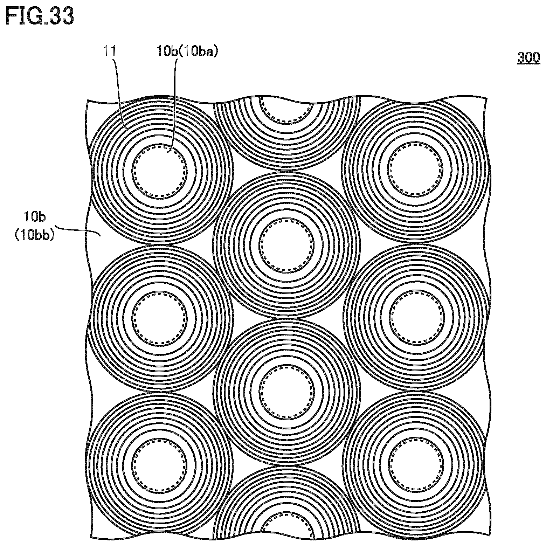

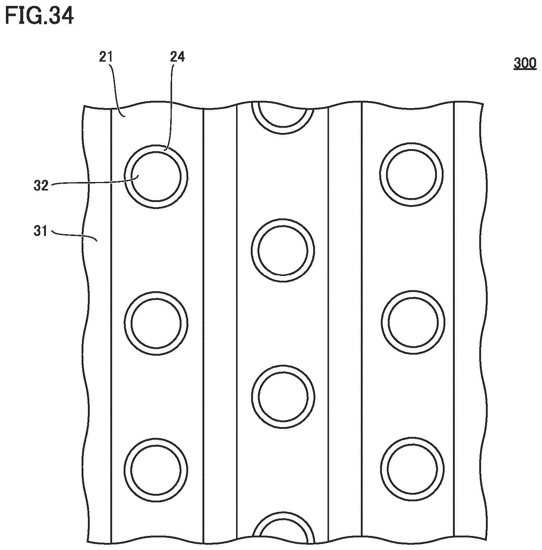

Fig. 33 is a plan view of semiconductor light-emitting element 300 according to a modification. Fig. 34 is a plan view of semiconductor light-emitting element 300 according to the modification as viewed from the side opposite to that shown in Fig. 33. As shown in Figs. 33 and 34, in semiconductor light-emitting element 300, each of mesa structure 24, first regions 10ba, and Fresnel zone plate structure 11 may be more than one in number.

### <Effects of Semiconductor Light-Emitting Element 300>

The following describes the effects of semiconductor light-emitting element 300 in comparison with the semiconductor light-emitting element according to Comparative Example 6. The semiconductor light-emitting element according to Comparative Example 6 is referred to as a semiconductor light-emitting element 300A. The configuration of semiconductor light-emitting element 300A is the same as that of semiconductor light-emitting element 300 except that second main surface 10b is configured as a flat surface (Fresnel zone plate structure 11 is not formed on second main surface 10b).

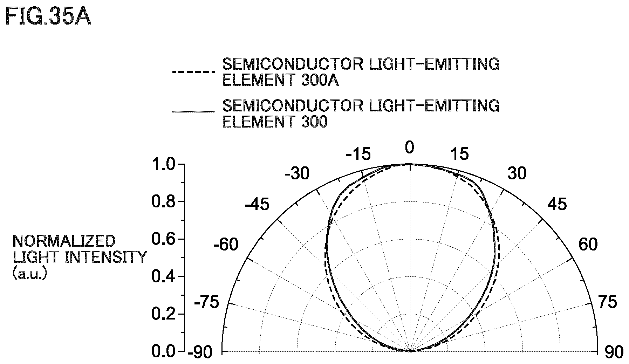

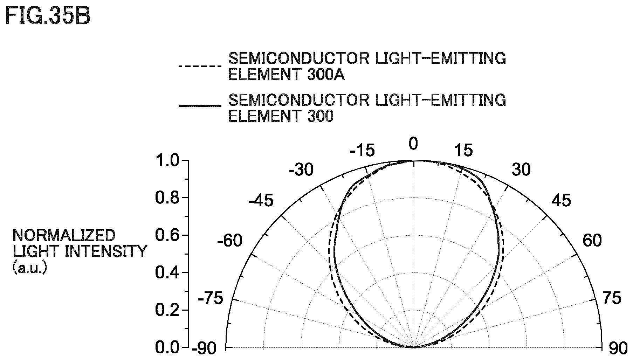

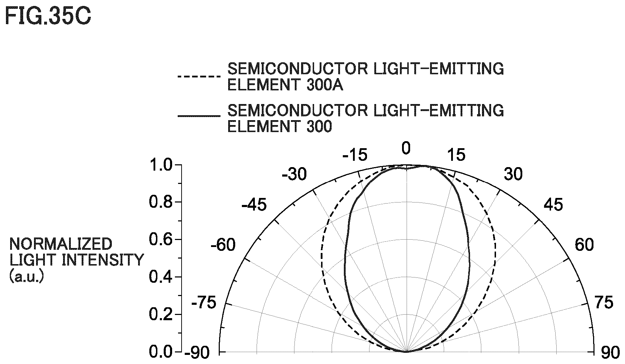

Fig. 35A is a graph showing the relation between an emission angle and intensity of deep ultraviolet light extracted from second main surface 10b in each of semiconductor light-emitting elements 300 and 300A on condition that diameter D3 is 210 µm. Fig. 35B is a graph showing the relation between the emission angle and the intensity of the deep ultraviolet light extracted from second main surface 10b in each of semiconductor light-emitting elements 300 and 300A on condition that diameter D3 is 250 µm. Fig. 35C is a graph showing the relation between the emission angle and the intensity of the deep ultraviolet light extracted from second main surface 10b in each of semiconductor light-emitting elements 300 and 300A on condition that diameter D3 is 333 µm.

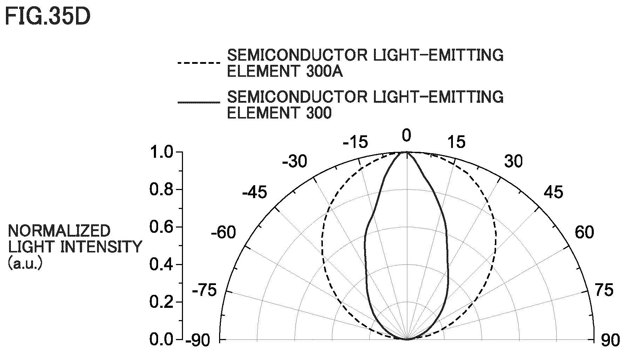

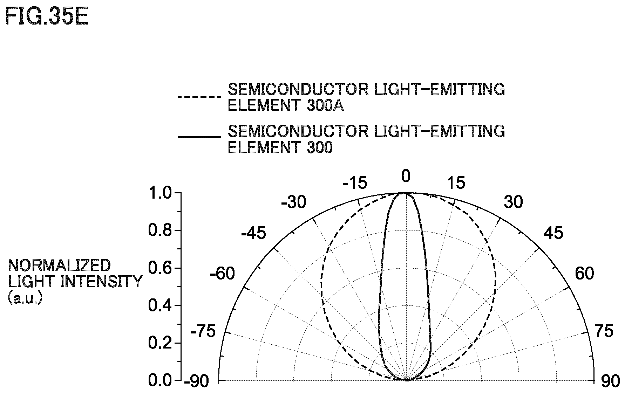

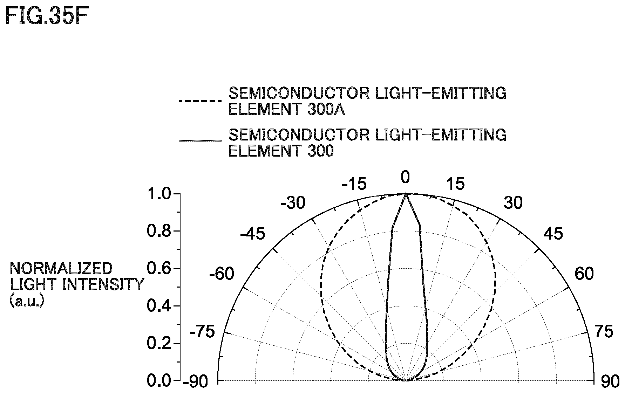

Fig. 35D is a graph showing the relation between the emission angle and the intensity of the deep ultraviolet light extracted from second main surface 10b in each of semiconductor light-emitting elements 300 and 300A on condition that diameter D3 is 500 µm. Fig. 35E is a graph showing the relation between the emission angle and the intensity of the deep ultraviolet light extracted from second main surface 10b in each of semiconductor light-emitting elements 300 and 300A on condition that diameter D3 is 1000 µm. Fig. 35F is a graph showing the relation between the emission angle and the intensity of the deep ultraviolet light extracted from second main surface 10b in each of semiconductor light-emitting elements 300 and 300A on condition that diameter D3 is 2000 µm.In Figs. 35A to 35F, in semiconductor light-emitting element 300, diameter D1 is 100 µm, a single crystal substrate made of aluminum nitride and having thickness T of 100 µm is used as substrate 10, λ is 265 nm, height H is 103 nm, a taper angle is 82°, and the diameter of first region 10ba on the innermost circumference of Fresnel zone plate structure 11 is 10.3 µm (0.1 times as large as diameter D1).

As shown in Figs. 35A to 35F, in semiconductor light-emitting element 300, the intensity of the deep ultraviolet light steeply decreases as the emission angle of the deep ultraviolet light extracted from second main surface 10b deviates from 0°. When diameter D3 is 500 µm or more (diameter D3 is 5 times or more as large as diameter D1), the intensity of the deep ultraviolet light particularly steeply decreases as the emission angle of the deep ultraviolet light extracted from second main surface 10b deviates from 0°. On the other hand, in semiconductor light-emitting element 300A, the intensity of the deep ultraviolet light does not steeply decrease as the emission angle of the deep ultraviolet light extracted from second main surface 10b deviates from 0°. In this way, according to semiconductor light-emitting element 300, Fresnel zone plate structure 11 constituted of the plurality of annular protrusions 10d functions as a collimating lens, and thus, the directivity of the deep ultraviolet light extracted from second main surface 10b can be enhanced. In other words, according to semiconductor light-emitting element 300, the light distribution characteristics of the deep ultraviolet light extracted from second main surface 10b can be controlled without using an optical lens (free of optics).

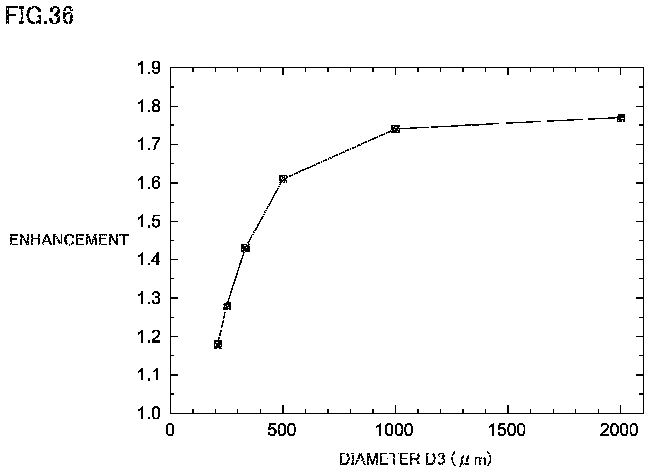

Fig. 36 is a graph showing the relation between diameter D3 and the enhancement in semiconductor light-emitting element 300. In Fig. 36, diameter D1 is 100 µm, a current is 5 mA, and a single crystal substrate made of aluminum nitride and having thickness T of 100 µm is used as substrate 10. As shown in Fig. 36, in semiconductor light-emitting element 300, the extraction efficiency for deep ultraviolet light (enhancement) increases as diameter D3 increases. More specifically, when diameter D3 is 500 µm or more (diameter D3 is 5 times as large as diameter D1), the extraction efficiency for deep ultraviolet light is particularly improved.

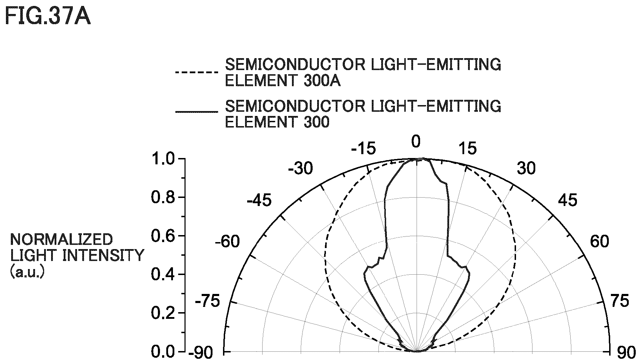

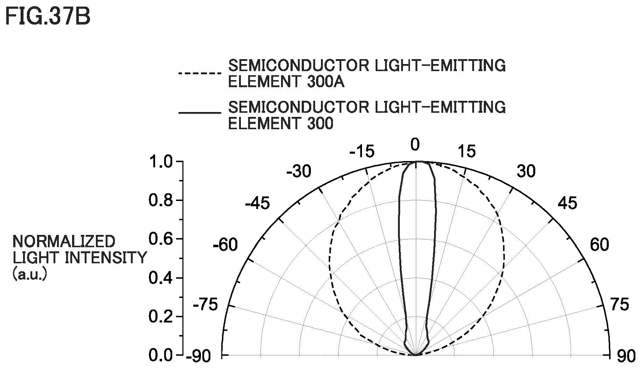

Fig. 37A is a graph showing the relation between the emission angle and the intensity of the deep ultraviolet light extracted from second main surface 10b in semiconductor light-emitting element 300 on condition that the constituent material of substrate 10 is sapphire. Fig. 37B is a graph showing the relation between the emission angle and the intensity of the deep ultraviolet light extracted from second main surface 10b in semiconductor light-emitting element 300 on condition that the constituent material of substrate 10 is aluminum nitride. In Fig. 37A, thickness T is 330 µm, and diameter D3 is 2500 µm. In Fig. 37B, thickness T is 392 µm, and diameter D3 is 2500 µm.

In the case where the constituent material of substrate 10 is sapphire, the difference in refractive index between semiconductor layer 20 and substrate 10 is larger than that in the case where the constituent material of substrate 10 is aluminum nitride. Thus, as shown in Figs. 37A and 37B, it was newly found that, in the case where the constituent material of substrate 10 is sapphire, the ghost peak (Airy disk) intensity resulting from scattering and diffraction between substrate 10 and semiconductor layer 20 becomes significant, and the directivity of the deep ultraviolet light extracted from second main surface 10b decreases, as compared with the case where the constituent material of substrate 10 is aluminum nitride. Thus, in semiconductor light-emitting element 300, aluminum nitride is used as the constituent material of substrate 10 based on the above-mentioned finding, so that the directivity of the deep ultraviolet light extracted from second main surface 10b can be further enhanced.

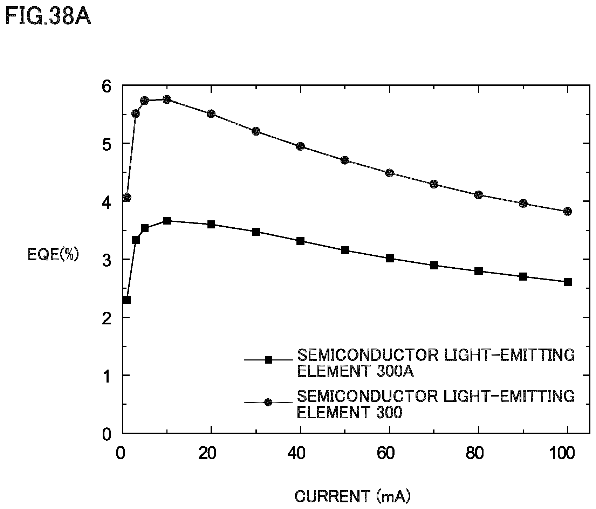

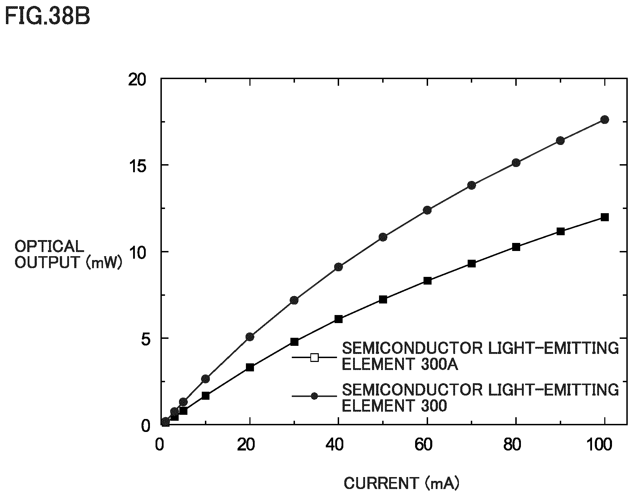

Fig. 38A is a graph showing the relation between the current and the external quantum efficiency in each of semiconductor light-emitting elements 300 and 300A. Fig. 38B is a graph showing the relation between the current and the optical output in each of semiconductor light-emitting elements 300 and 300A. In Figs. 38A and 38B, diameter D1 is 100 µm, thickness T is 100 µm, the pitch between two adjacent mesa structures 24 is 210 µm, λ is 267 nm, and the chip size of the semiconductor light-emitting element is 2 mm × 2 mm.

As shown in Figs. 38A and 38B, in the case where mesa structure 24 is more than one in number, semiconductor light-emitting element 300 is enhanced in extraction efficiency for the deep ultraviolet light (the external quantum efficiency, the optical output) from second main surface 10b as compared with semiconductor light-emitting element 300A. More specifically, in semiconductor light-emitting element 300, the external quantum efficiency occurring when a current of 20 mA flows is 1.53 times as large as that in the case of semiconductor light-emitting element 300A, and the external quantum efficiency occurring when a current of 20 mA flows is 1.53 times as large as that in the case of semiconductor light-emitting element 300A. Further, in semiconductor light-emitting element 300, the optical output occurring when a current of 100 mA flows is 1.47 times as large as that in the case of semiconductor light-emitting element 300A. In this way, semiconductor light-emitting element 300 includes the plurality of mesa structure 24, the plurality of first regions 10ba, and the plurality of Fresnel zone plate structures 11, and therefore, enables enhancement of the extraction efficiency for deep ultraviolet light from second main surface 10b.

### (Fourth Embodiment)

A light-emitting module (a light-emitting module 400) according to the fourth embodiment will be hereinafter described.

### <Configuration of Light-Emitting Module 400>

The following describes the configuration of light-emitting module 400.

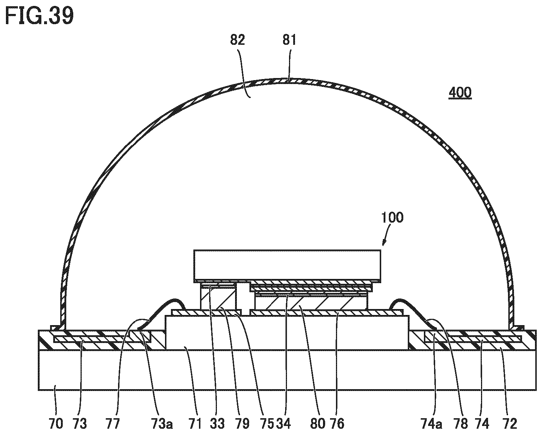

Fig. 39 is a cross-sectional view of light-emitting module 400. As shown in Fig. 39, light-emitting module 400 includes a base 70, a submount 71, an insulating layer 72, wires 73 and 74, connection pads 75 and 76, bonding wires 77 and 78, connection members 79 and 80, a transparent member 81, and a liquid 82.

The constituent material of base 70 is, for example, a metal material, a resin material, a ceramic material, or the like. The constituent material of base 70 preferably has high thermal conductivity. In this case, base 70 functions as a heat sink. Submount 71 is disposed on base 70. The constituent material of submount 71 is preferably a material having high thermal conductivity, such as aluminum nitride, silicon, silicon carbide (SiC), diamond, or the like.

Insulating layer 72 is disposed on base 70 so as to surround the outer periphery of submount 71. Wires 73 and 74 are embedded, for example, in insulating layer 72. Wire 73 has one end provided with a pad 73a and the other end through which it receives power from the outside. Wire 74 has one end provided with a pad 74a and the other end through which it receives power from the outside. Pads 73a and 74a are exposed from insulating layer 72.

Connection pads 75 and 76 are disposed on submount 71. Bonding wire 77 has one end connected to pad 73a and the other end connected to connection pad 75. Bonding wire 78 has one end connected to pad 74a and the other end connected to connection pad 76. Connection pad 75 is connected to pad electrode 33 by connection member 79. Connection pad 76 is connected to pad electrode 34 by connection member 80. The constituent material of each of connection members 79 and 80 is, for example, a gold-tin alloy. **In** this way, pad electrode 33 is electrically connected to wire 73 via connection member 79 and bonding wire 77, and pad electrode 34 is electrically connected to wire 74 via connection member 80 and bonding wire 78, with the result that deep ultraviolet light is generated from active layer 22 based on the current applied between the other end of wire 73 and the other end of wire 74.

Transparent member 81 has, for example, a hemispherical shape that is increased in diameter from one end toward the other end and that is open at the other end. The other end of transparent member 81 is connected onto insulating layer 72, for example, with an adhesive. Transparent member 81 is transparent to deep ultraviolet light generated from active layer 22. Transparent member 81 has a transmittance, for example, of 60 percent or more with respect to the deep ultraviolet light generated from active layer 22. The constituent material of transparent member 81 is, for example, an inorganic material or a resin material. Specific examples of the inorganic material include synthetic quartz, quartz glass, alkali-free glass, sapphire, fluorite (CaF), and the like. Specific examples of the resin material include a silicone resin having no aromatic ring, an amorphous fluorine-containing resin, polyimide, an epoxy resin, and the like. The resin material may contain an inorganic material.

Semiconductor light-emitting element 100 is disposed inside transparent member 81. Although not shown, semiconductor light-emitting element 200 or 300 may be used in place of semiconductor light-emitting element 100. Liquid 82 fills the inside of transparent member 81. Thus, semiconductor light-emitting element 100 is sealed with liquid 82. Liquid 82 is transparent to the deep ultraviolet light generated from active layer 22. Liquid 82 has a transmittance, for example, of 60 percent or more with respect to the deep ultraviolet light generated from active layer 22. Liquid 82 is, for example, pure water, a liquid organic compound, a salt solution, a solution containing dispersed particles, or the like.

### <Modification>

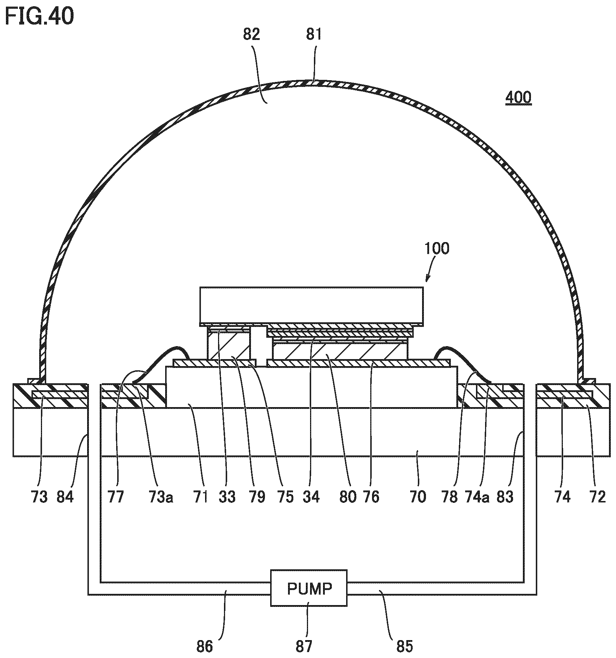

Fig. 40 is a cross-sectional view of a light-emitting module 400 according to a modification. As shown in Fig. 40, light-emitting module 400 may be provided with a through hole 83 and a through hole 84. Through holes 83 and 84 penetrate base 70 and insulating layer 72. Light-emitting module 400 may further include a pipe 85, a pipe 86, and a pump 87. Pipe 85 has one end connected to through hole 83. Pipe 86 has one end connected to through hole 84. Pipes 85 and 86 each have the other end connected to pump 87. Pump 87 causes liquid 82 inside transparent member 81 to circulate through pipes 85 and 86. This promotes cooling of semiconductor light-emitting element 100 by liquid 82.

Although the embodiments of the present disclosure have been described above, the above-described embodiments may be variously modifiable. Further, the scope of the present invention is not limited to the above-described embodiments. The scope of the present invention is defined by the terms of the claims, and is intended to include any modifications within the scope and meaning equivalent to the terms of the claims.

### REFERENCE SIGNS LIST

100, 100A, 100B, 200, 200A, 200B, 200C, 300, 300A semiconductor light-emitting element, 10 substrate, 10a first main surface, 10b second main surface, 10ba first region, 10bb second region, 10c uneven structure, 10d annular protrusion, 11 Fresnel zone plate structure, 20 semiconductor layer, 21 n-type semiconductor layer, 22 active layer, 23 p-type semiconductor layer, 23a electron blocking layer, 23b cladding layer, 23c contact layer, 24 mesa structure, 24a straight portion, 31 n-electrode, 32 p-electrode, 33 pad electrode, 34 pad electrode, 40 anti-reflection film, 50 first layer, 50a opening, 51 second layer, 51a opening, 52 third layer, 52a recess, 52b opening, 60 columnar structure, 70 base, 71 submount, 72 insulating layer, 73 wire, 73a pad, 74 wire, 74a pad, 75, 76 connection pad, 77, 78 bonding wire, 79, 80 connection member, 81 transparent member, 82 liquid, 83, 84 through hole, 85, 86 pipe, 87 pump, 400 light-emitting module, T thickness, W1, W2 width, rₖ radius, D1, D2, D3 diameter, H height, DR1 first direction, DR2 second direction, S1 preparing step, S2 semiconductor layer forming step, S3 mesa structure forming step, S4 first electrode forming step, S5 second electrode forming step, S6 substrate back surface processing step, S7 mask forming step, S8 columnar structure forming step, S9 uneven structure forming step, S10 singulating step.

## Claims

1. A semiconductor light-emitting element comprising:
a substrate; and
a semiconductor layer, wherein
the substrate has a first main surface and a second main surface opposite to the first main surface,
the semiconductor layer has
an n-type semiconductor layer disposed on the first main surface,
an active layer disposed on the n-type semiconductor layer to generate deep ultraviolet light, and
a p-type semiconductor layer disposed on the active layer,
the semiconductor layer has a mesa structure,
the second main surface has a first region facing the mesa structure and a second region located around the first region,
the first region is configured as a flat surface,
the second region is provided with an uneven structure, and
in a plan view, a width of the first region is 0.1 times or more and 3.0 times or less as large as a width of the mesa structure.

2. The semiconductor light-emitting element according to claim 1, wherein the uneven structure is formed in a lattice pattern to have a period of 1000 nm or less in a plan view.

3. The semiconductor light-emitting element according to claim 1, wherein the mesa structure has a straight portion extending in a first direction in a plan view.

4. The semiconductor light-emitting element according to claim 3, wherein, in a cross-sectional view orthogonal to the first direction, a width of a portion of the first region in a second direction orthogonal to the first direction is 0.4 times or more and 1.8 times or less as large as a width of the straight portion in the second direction, the portion of the first region facing the straight portion.

5. The semiconductor light-emitting element according to claim 3, wherein, in a plan view, a distance between a center of the mesa structure in a second direction orthogonal to the first direction and a center of a portion of the first region in the second direction is 0.05 times or less as large as a width of the mesa structure in the second direction, the portion of the first region facing the straight portion.

6. The semiconductor light-emitting element according to claim 1, wherein the mesa structure and the first region are circular in a plan view.

7. The semiconductor light-emitting element according to claim 6, wherein a diameter of the first region in a plan view is 0.5 times or more and 3.0 times or less as large as a diameter of the mesa structure in a plan view.

8. The semiconductor light-emitting element according to claim 6, wherein, in a plan view, a distance between a center of the mesa structure and a center of the first region is 0.05 times or less as large as a diameter of the mesa structure.

9. The semiconductor light-emitting element according to claim 1, further comprising an anti-reflection film disposed on the first region.

10. The semiconductor light-emitting element according to claim 1, wherein a constituent material of the substrate is single-crystalline aluminum nitride.

11. The semiconductor light-emitting element according to claim 1, wherein
the mesa structure is circular in a plan view, and
the uneven structure has a plurality of annular protrusions concentrically arranged at intervals in a plan view so as to form a Fresnel zone plate structure.

12. The semiconductor light-emitting element according to claim 11, wherein a constituent material of the substrate is single-crystalline aluminum nitride.

13. The semiconductor light-emitting element according to claim 11, wherein each of the mesa structure, the first region, and the Fresnel zone plate structure is more than one in number.

14. The semiconductor light-emitting element according to claim 11, wherein, in a plan view, a distance between a center of the mesa structure and a center of the first region is 0.05 times or less as large as a diameter of the mesa structure.

15. A light-emitting module comprising:
the semiconductor light-emitting element according to any one of claims 1 to 14;
a transparent member; and
a liquid, wherein
the semiconductor light-emitting element is disposed inside the transparent member,
the liquid fills an inside of the transparent member to seal the semiconductor light-emitting element, and
the transparent member and the liquid are transparent to the deep ultraviolet light.
